(19) Europäisches Patentamt
European Patent Office
Office européen des brevets

(11) EP 4 462 977 A1

(12) EUROPEAN PATENT APPLICATION

(43) Date of publication:
**13.11.2024 Bulletin 2024/46**

(21) Application number: **24175170.0**

(22) Date of filing: **10.05.2024**

(51) International Patent Classification (IPC):
***H10K 50/115*** $^{(2023.01)}$ ***H10K 50/16*** $^{(2023.01)}$

(52) Cooperative Patent Classification (CPC):
**H10K 50/115; H10K 50/16;** H10K 2102/331

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.05.2023 KR 20230061932**

(71) Applicant: **Samsung Electronics Co., Ltd.**
**Suwon-si, Gyeonggi-do 16677 (KR)**

(72) Inventors:
- **KIM, Sung Woo**
**16677 Suwon-si (KR)**
- **CHUNG, You Jung**
**16677 Suwon-si (KR)**
- **KIM, Dongchan**
**16677 Suwon-si (KR)**
- **KIM, Enjung**
**16677 Suwon-si (KR)**
- **KIM, Chan Su**
**16677 Suwon-si (KR)**
- **SEO, Hong Kyu**
**16677 Suwon-si (KR)**
- **LEE, Ilyoung**
**16677 Suwon-si (KR)**
- **HWANG, Sungwoo**
**16677 Suwon-si (KR)**

(74) Representative: **Elkington and Fife LLP**
**Prospect House**
**8 Pembroke Road**
**Sevenoaks, Kent TN13 1XR (GB)**

# (54) ELECTROLUMINESCENT DEVICE, PRODUCTION METHOD THEREOF, AND DISPLAY DEVICE INCLUDING THE SAME

(57) An electroluminescent device, a method of manufacturing the same, and a display device including the same are provided. The method of manufacturing the electroluminescent device comprises disposing a light emitting layer including a semiconductor nanoparticle on a first electrode; depositing a composition including a zinc oxide nanoparticle containing a first metal onto the light emitting layer to provide an electron transport layer; and disposing a second electrode on the electron transport layer to provide the electroluminescent device. The first metal includes an alkaline earth metal, zirconium, tungsten, titanium, yttrium, aluminum, gallium, indium, tin, cobalt, vanadium, or a combination thereof. The zinc oxide nanoparticle has a particle size of 1 nanometer or more and 50 nanometers or less. Preparation of the zinc oxide nanoparticle includes contacting a first metal precursor, a zinc precursor, a base, and a metal carbonate in an organic solvent to form the zinc oxide nanoparticle.

FIG. 2

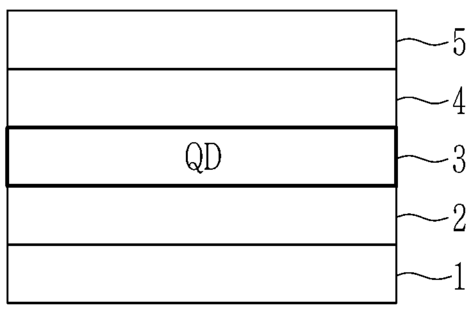




Processed by Luminess, 75001 PARIS (FR)

## Description

### FIELD OF THE INVENTION

The present disclosure relates to a light emitting (e.g., electroluminescent) device, a production method thereof, and a display device including the electroluminescent device.

### BACKGROUND OF THE INVENTION

A semiconductor nanoparticle (e.g., a semiconductor nanocrystal particle) having a nanometer size may exhibit luminescence properties. For example, a quantum dot including a semiconductor nanocrystal may exhibit a quantum confinement effect. The light emission from the semiconductor nanoparticle may occur when an electron in an excited state resulting from light excitation or an applied voltage moves from a conduction band to a valence band. The semiconductor nanoparticle may be configured to emit light of a desired wavelength region by adjusting a size of the semiconductor nanoparticle, a composition of the semiconductor nanoparticle, or a combination thereof.

The semiconductor nanoparticle may be used, for example, in a light emitting device (e.g., an electroluminescent device) or a display device including the electroluminescent device. There remains a need for an improved light emitting device.

### SUMMARY OF THE INVENTION

An embodiment provides a method of producing a light emitting device that emits light, for example, by applying a voltage to a nanostructure (e.g., a semiconductor nanoparticle such as a quantum dot), for example with or without a separate irradiation light source.

An embodiment provides a light emitting device prepared by the method of an embodiment.

An embodiment provides a display device (e.g., a quantum dot-light emitting diode (QD-LED) display device) that includes a semiconductor nanoparticle such as a quantum dot as a component of a light emitting layer in a pixel configuration (e.g., in a configuration of a blue pixel, a red pixel, a green pixel, or a combination thereof).

In an embodiment, a method for producing an electroluminescent includes:

disposing a light emitting layer including a semiconductor nanoparticle on a first electrode;
providing a zinc oxide nanoparticle (e.g., a plurality of zinc oxide nanoparticle), the zinc oxide nanoparticle including a first metal;
depositing a composition including the zinc oxide nanoparticle onto the light emitting layer to provide an electron transport layer (e.g., on the light emitting layer); and disposing a second electrode on the electron transport layer to provide the electroluminescent device. The first metal includes an alkaline earth metal, zirconium, tungsten, titanium, yttrium, aluminum, gallium, indium, tin, cobalt, vanadium, or a combination thereof. The zinc oxide nanoparticle has a particle size (e.g., an average particle size) of greater than or equal to about 1 nanometer and less than or equal to about 50 nanometers. The providing of the zinc oxide nanoparticle includes contacting a first metal precursor, a zinc precursor, a base, and a metal carbonate compound in an organic solvent to form the zinc oxide nanoparticle.

The first metal may include an alkaline earth metal (e.g., magnesium), zirconium, tungsten, titanium, yttrium, aluminum, gallium, indium, tin, cobalt, vanadium, or a combination thereof.

The first metal may include an alkali earth metal (e.g., magnesium); and optionally zirconium, tungsten, titanium, yttrium, aluminum, Ga, In, Sn, Co, V, or a combination thereof.

The first metal may include magnesium and gallium.

The providing of the zinc oxide nanoparticle or the contacting may include dissolving the first metal precursor and the zinc precursor in the organic solvent to obtain a first solution. The providing of the zinc oxide nanoparticle or the contacting may include adding the base and the metal carbonate compound to the organic solvent before dissolving the first metal precursor and the zinc precursor in the organic solvent or adding the base and the metal carbonate compound to the first solution. The zinc precursor and the first metal precursor may be allowed to react in the presence of the base and the metal carbonate compound.

The semiconductor nanoparticle or the light emitting layer may not include cadmium.

The contacting (or a reaction between the zinc precursor and the first metal precursor) may be carried out in the absence of an ethanolamine (e.g., monoethanolamine). The composition or the organic solvent may include or may not include a C1 to C12 organic amine, an aromatic amine with a benzene group, or a combination thereof.

The zinc oxide nanoparticle may further include or may not include lithium, sodium, potassium, rubidium, cesium, francium, or a combination thereof.

The organic solvent may include a C1 to C10 alcohol solvent, dimethyl sulfoxide, a C3 to C30 hydrocarbon solvent, or a combination thereof.

The organic solvent may be a solvent mixture including a first solvent and a second solvent, and the first solvent and the second solvent may have a relative polarity difference of greater than or equal to about 0.3 and less than or equal to about 0.9.

The first solvent may be a C1 to C10 alcohol solvent. The second solvent may be a C3 to C30 (e.g., C15) hydrocarbon solvent (e.g., an aliphatic hydrocarbon solvent, an aromatic hydrocarbon solvent, an alicyclic hydrocarbon solvent, or a solvent having a benzene ring in which one or more double bonds are hydrogenated).

A ratio between the first solvent and the second solvent (as a volume ratio, first solvent:second solvent) may be about 1:0.3 to about 1:3, or about 1:0.5 to about 1:2, or about 1:1.

The method may further include stirring the solvent mixture of the first solvent and the second solvent, for example, at a predetermined temperature (for example, at a temperature of greater than or equal to about 40 °C and greater than or equal to about 80 °C).

The stirring may be conducted at about 100 rpm or more (e.g., about 300 rpm to about 700 rpm or about 400 rpm to about 500 rpm, or a combination thereof).

As determined by X-ray Photoelectron Spectroscopy (XPS) analysis, the electron transport layer may not exhibit a peak assigned to rubidium, cesium, or a combination thereof.

The base may have a pH of greater than about 8, greater than or equal to about 8.5, or greater than or equal to about 9. The base may be a strong base.

The base may include a first base, a second base, or a combination thereof.

The first base may include an organic base including a C1 to C50 organic group.

The second base may include an inorganic base including an alkali metal or an alkaline earth metal.

The first base may include a quaternary ammonium salt compound (e.g., a tetraalkyl ammonium hydroxide). The second base may include a hydroxide of an alkali metal (lithium, sodium, potassium, rubidium, cesium, or francium) or a combination thereof. The base may not include the second base. The base may not include the first base.

In an embodiment, the second base is present and a mole ratio (the second base:the first base) between the second base and the first base may be from about 1:0 to about 1:10, from about 1:0.1 to about 1:10, from about 1:0.05 to about 1:6, from about 1:0.1 to about 1:4.5, from about 1:0.3 to about 1:3, from about 1:0.8 to about 1:1.5, from about 1:0.9 to about 1:1.3, from about 1:1 to about 1:1.25, or a combination thereof.

A mole ratio of a total sum of the first base and the second base to a total sum of the zinc precursor and the first metal precursor may be from about 1:0.5 to about 1:5, from about 1:0.9 to about 1:2, or a combination thereof.

The metal carbonate compound may include an alkali metal carbonate, an alkali metal bicarbonate, an alkaline earth metal carbonate, or a combination thereof. The metal carbonate compound may include sodium, potassium, rubidium, cesium, francium, or a combination thereof.

The metal carbonate compound may include a metal having an atomic radius greater than that of zinc.

In an embodiment, the base may include a C1 to C30 alkylammonium hydroxide, an alkali metal hydroxide, or a combination thereof, and the metal carbonate compound may include a rubidium carbonate, a rubidium bicarbonate, a cesium carbonate, a cesium bicarbonate, or a combination thereof.

In the method, the zinc oxide nanoparticle may have a core-shell structure.

In the method of an embodiment, the preparation of a core-shell structured zinc oxide nanoparticle may further include contacting the prepared zinc oxide nanoparticle, an additional metal precursor and a third base in a third solvent to form an additional metal-containing layer (hereinafter, also referred to as a shell layer) on the zinc oxide nanoparticle. The additional metal may include an alkaline earth metal, zirconium, tungsten, titanium, yttrium, aluminum, gallium, indium, tin, cobalt, vanadium, or a combination thereof. The additional metal may be the same as or different from the first metal. The contacting may include adding a zinc oxide nanoparticle, the additional metal precursor, and the third base into the third solvent. The contacting may include or involve a reaction of the additional metal precursor.

The third solvent may include a C1 to C10 alcohol solvent, dimethylsulfoxide, a C3 to C30 (e.g., C15) hydrocarbon solvent (e.g., an aliphatic hydrocarbon solvent, an aromatic hydrocarbon solvent, an alicyclic hydrocarbon solvent, or a solvent having a benzene ring in which one or more double bonds are hydrogenated).

The third base for forming the additional metal-containing layer may be the same as described herein for the first and the second base.

In ultraviolet-visible (UV-Vis) absorption spectroscopy analysis, the zinc oxide nanoparticle may exhibit a first absorption peak in a range of greater than or equal to about 285 nanometers (nm), greater than or equal to about 290 nm, or greater than or equal to about 292 nm and less than or equal to about 330 nm, or less than or equal to about 310 nm.

In a UV-Vis absorption spectrum, the zinc oxide nanoparticle may exhibit a valley that is adjacent to the first absorption peak, and a valley depth (VD) of the valley, defined by Equation 1, may be greater than or equal to about 0.03, or greater than or equal to about 0.05 and less than or equal to about 0.2, or less than or equal to about 0.12:

$$1 - (Abs_{valley}/Abs_{first}) = VD \qquad (1)$$

wherein $Abs_{first}$ is an absorbance at a wavelength of the first absorption peak and $Abs_{valley}$ is an absorbance at a lowest point of the valley.

In a UV-Vis absorption spectrum, the zinc oxide nanoparticle may exhibit an x-intercept of less than or equal to about 332 nm, for example less than or equal to about 331 nm and greater than or equal to about 300 nm.

In a thermogravimetric analysis, the zinc oxide nanoparticle or the electron transport layer may exhibit a weight loss at a decomposition temperature of greater than or equal to about 500 °C (or about 600 °C) that is greater than or equal to about 26 weight percent (wt%), for example, greater than or equal to about 30 wt%, based on the total weight of the zinc oxide nanoparticle or electron transport layer.

In a thermogravimetric analysis, the zinc oxide nanoparticle or the electron transport layer may exhibit a weight loss at a decomposition temperature of greater than or equal to about 500 °C (or about 600 °C) that is less than or equal to about 55 wt%, for example, less than or equal to about 45 wt%, less than or equal to about 40 wt%, or less than or equal to about 35 wt%, based on the total weight of the zinc oxide nanoparticle or electron transport layer.

In a derivative of a thermogravimetric analysis curve (DTGA), the zinc oxide nanoparticle or the electron transport layer may exhibit a temperature of a maximum weight loss (hereinafter, a maximum weight loss temperature) that is greater than or equal to about 200 °C, greater than or equal to about 250 °C, or greater than or equal to about 300 °C. The maximum weight loss temperature may be less than or equal to about 400 °C, or less than or equal to about 380 °C.

The composition may not include a cesium carbonate, a rubidium carbonate, a lithium carbonate, a sodium carbonate, a potassium carbonate, or a combination thereof.

In an X-ray photoelectron spectroscopy (XPS) analysis, the zinc oxide nanoparticle may exhibit an O1s peak with a full width at half maximum (FWHM) of less than about 4 electronvolts (eV), less than or equal to about 3.5 eV, less than or equal to about 3 eV, or less than or equal to about 2.9 eV.

The O1s peak may have a half width at half maximum (HWHM) of less than or equal to about 2.5 eV, or less than or equal to about 1.9 eV.

In an embodiment, an electroluminescent device includes:

a first electrode and a second electrode spaced apart from each other;
a light emitting layer disposed between the first electrode and the second electrode; and
an electron transport layer disposed between the light emitting layer and the second electrode,
wherein the light emitting layer includes a semiconductor nanoparticle,
wherein the electron transport layer includes a zinc oxide nanoparticle described herein. The zinc oxide nanoparticle further includes a first metal. The first metal includes an alkaline earth metal, zirconium, tungsten, titanium, yttrium, aluminum, gallium, indium, tin, cobalt, vanadium, or a combination thereof. The first metal may include the alkaline earth metal, and optionally zirconium, tungsten, titanium, yttrium, aluminum, gallium, indium, tin, cobalt, vanadium, or a combination thereof. The zinc oxide nanoparticle has a size of greater than or equal to about 1 nanometer and less than or equal to about 50 nanometers. In an X-ray Photoelectron Spectroscopy (XPS) analysis of the zinc oxide nanoparticle, an O1s XPS intensity spectrum has a full width at half maximum (FWHM) of 3 eV or less. The light emitting layer is configured to emit a first light and the electroluminescent device is configured to exhibit a maximum luminance of greater than or equal to about 60,000 candela per square meter ($cd/m^2$, nit).

The zinc oxide nanoparticles can be prepared by the method described herein.

The O1s XPS intensity spectrum may have a full width at half maximum (FWHM) of less than or equal to about 2.3 eV, or less than or equal to about 2.1 eV. The O1s XPS intensity spectrum may have a full width at half maximum of greater than or equal to about 1 eV, or greater than or equal to about 1.5 eV.

The O1s XPS intensity spectrum may have a half width at half maximum (HWHM) of less than or equal to about 2.5 eV, less than or equal to about 1.9 eV, less than or equal to about 1.2 eV, or less than or equal to about 1.1 eV

A maximum luminance of the electroluminescent device may be greater than or equal to about 85,000 nit.

In the O1s XPS intensity spectrum, a ratio of an intensity at 530 eV to a maximum intensity may be less than or equal to about 0.3:1, less than or equal to about 0.25:1, or less than or equal to about 0.22:1.

The O1s XPS intensity spectrum may exhibit a first peak corresponding to a metal oxide and a second peak corresponding to an oxygen vacancy, wherein a binding energy of the first peak may be greater than binding energy of the second peak and a ratio of a maximum intensity of the first peak to maximum intensity of the second peak (the maximum intensity of the first peak:the maximum intensity of the second peak) may be less than or equal to about 0.55:1.

In the O1s XPS intensity spectrum, a binding energy at the maximum intensity of the first peak may be greater than or equal to about 525 eV, greater than or equal to about 530 eV, and less than or equal to about 540 eV, or less than or equal to about 535 eV.

In the O1s XPS intensity spectrum, a binding energy at the maximum intensity of the second peak may be greater than or equal to about 525 eV, greater than or equal to about 530 eV, and less than or equal to about 540 eV, or less than or equal to about 535 eV.

As determined by the XPS analysis, a Zn2p XPS intensity spectrum of the zinc oxide nanoparticle may have a maximum intensity of a peak corresponding to Zn2p at a binding energy in a range of greater than or equal to about 1040 eV and less than or equal to about 1050 eV, greater than or equal to about 1042 eV and less than or equal to about 1047.5 eV, or greater than or equal to about 1042.5 eV and less than or equal to about 1045 eV.

As determined by X-ray Photoelectron Spectroscopy (XPS) analysis, the electron transport layer of the electroluminescent device may not exhibit a peak assigned to rubidium, cesium, or a combination thereof.

The electron transport layer or the zinc oxide nanoparticle may include or may not include an alkali metal (e.g., rubidium). In an embodiment, the electron transport layer or the zinc oxide nanoparticle may include or may not include lithium, potassium, rubidium, cesium, or a combination thereof. In an example, the electron transport layer or the zinc oxide nanoparticle may further include rubidium, and in an XPS analysis, the electron transport layer or the zinc oxide nanoparticle may exhibit a peak of Rb3p that is in a range of greater than or equal to about 230 eV and less than or equal to about 245 eV or greater than or equal to about 230 eV and less than or equal to about 240 eV.

The first metal may include magnesium and optionally gallium.

In the zinc oxide nanoparticle, the molar ratio of magnesium to zinc may be less than or equal to about 0.5:1, less than or equal to about 0.25:1, less than or equal to about 0.14:1, or less than or equal to about 0.13:1. In the zinc oxide nanoparticles, the molar ratio of magnesium to zinc may be greater than or equal to about 0.01:1, greater than or equal to about 0.07:1, greater than or equal to about 0.1:1, greater than or equal to about 0.12:1, or greater than or equal to about 0.15:1.

In the zinc oxide nanoparticle, an amount of gallium may be greater than or equal to about 3 mole percent (mol%), greater than or equal to about 3.5 mol% and less than or equal to about 25 mol%, less than or equal to about 19 mol%, or less than or equal to about 17.5 mol%, based on total moles of zinc, magnesium, and gallium. In the zinc oxide nanoparticle, the gallium content may be greater than or equal to about 10 mol%, greater than or equal to about 12 mol% and less than or equal to about 16 mol%, based on total moles of zinc, magnesium, and gallium.

In the zinc oxide nanoparticles, a molar ratio of gallium to zinc (Ga:Zn) may be greater than or equal to about 0.03:1, greater than or equal to about 0.04:1, greater than or equal to about 0.08:1, greater than or equal to about 0.1:1, greater than or equal to about 0.15:1, greater than or equal to about 0.18:1, greater than or equal to about 0.19:1, or greater than or equal to about 0.2:1. In the zinc oxide nanoparticles, a molar ratio of gallium to zinc (Ga:Zn) may be less than or equal to about 0.3:1, less than or equal to about 0.25:1, less than or equal to about 0.23:1, or less than or equal to about 0.21:1.

In the zinc oxide nanoparticle, a molar ratio of gallium to magnesium (Ga:Mg) may be greater than or equal to about 0.3:1, greater than or equal to about 0.32:1, greater than or equal to about 0.5:1, greater than or equal to about 0.7:1, greater than or equal to about 1:1, greater than or equal to about 1.5:1, greater than or equal to about 1.9:1, or greater than or equal to about 2:1. In the zinc oxide nanoparticle, a molar ratio of gallium to magnesium (Ga:Mg) may be less than or equal to about 2.8:1, less than or equal to about 2.7:1, less than or equal to about 2.5:1, less than or equal to about 2.4:1, less than or equal to about 2:1, less than or equal to about 1.7:1, less than or equal to about 1.4:1, or less than or equal to about 0.9:1.

In the zinc oxide nanoparticle, a molar ratio of a total sum of magnesium and gallium to zinc [(Mg+Ga):Zn] may be greater than or equal to about 0.15:1, greater than or equal to about 0.18:1, greater than or equal to about 0.22:1, greater than or equal to about 0.24:1, greater than or equal to about 0.3:1, or greater than or equal to about 0.35:1. In the zinc oxide nanoparticle, a molar ratio of a total sum of magnesium and gallium to zinc [(Mg+Ga):Zn] may be less than or equal to about 0.5:1, less than or equal to about 0.45:1, less than or equal to about 0.4:1, less than or equal to about 0.35:1, less than or equal to about 0.31:1, less than or equal to about 0.29:1, less than or equal to about 0.26:1, less than or equal to about 0.23:1, or less than or equal to about 0.2:1.

The zinc oxide nanoparticles may include a core including $Zn_{1-x}M_xO$ (where M is Mg, Ca, Zr, W, Li, Ti, Y, Al, or a combination thereof, and $0 \leq x \leq 0.5$) and a gallium oxide shell disposed on the core. In the above formula, x may be greater than 0, greater than or equal to about 0.01, greater than or equal to about 0.03, greater than or equal to about 0.05, greater than or equal to about 0.1, or greater than or equal to about 0.15. The x may be less than or equal to about 0.45, or less than or equal to about 0.4.

In the zinc oxide nanoparticle, a thickness of the gallium oxide shell may be less than or equal to about 1 nm, or less than or equal to about 0.5 nm.

The size or average size (hereinafter referred to as the size) of the zinc oxide nanoparticle may be greater than or equal to about 3 nm. The size of the zinc oxide nanoparticle may be less than or equal to about 25 nm, less than or equal to about 10 nm, less than or equal to about 8 nm, less than or equal to about 5 nm, or less than or equal to about 4 nm.

The thickness of the electron transport layer may be greater than or equal to about 5 nm. The thickness of the electron transport layer may be less than or equal to about 70 nm.

The electron transport layer may be adjacent to the light emitting layer (e.g., disposed directly on the light emitting layer). The electroluminescent device may further include a hole auxiliary layer between the light emitting layer and the first electrode. The hole auxiliary layer may include a hole transport layer (e.g., including an organic compound), a hole injection layer, or a combination thereof.

The semiconductor nanoparticle or the light emitting layer may not include cadmium, lead, mercury, or a combination thereof.

The semiconductor nanoparticle may include a first semiconductor nanocrystal including (a zinc chalcogenide including) zinc, selenium, and tellurium, and a second semiconductor nanocrystal including a zinc chalcogenide, the second semiconductor nanocrystal being different from the first semiconductor nanocrystal.

The semiconductor nanoparticle may include a first semiconductor nanocrystal including (a Group III-V compound or an indium phosphide compound including) indium, phosphorus, and optionally zinc; and a second semiconductor nanocrystal including a zinc chalcogenide and different from the first semiconductor nanocrystal.

The semiconductor nanoparticle may include a zinc chalcogenide, the zinc chalcogenide may include tellurium, and the semiconductor nanoparticle may be configured to emit blue light or green light.

The electroluminescent device, or the light emitting layer, may be configured to emit green light with application of a voltage. The electroluminescent device or the light emitting layer may be configured to emit blue light with application of a voltage. The electroluminescent device or the light emitting layer may be configured to emit red light with application of a voltage.

The electroluminescent device has a maximum external quantum efficiency of greater than or equal to about 6%, greater than or equal to about 7%, greater than or equal to about 8%, greater than or equal to about 9%, greater than or equal to about 10%, greater than or equal to about 11%, greater than or equal to about 12%, greater than or equal to about 13%, or greater than or equal to about 14%. The maximum external quantum efficiency may be from about 6% to about 50%, or from about 10% to about 40%.

The electroluminescent device may have a maximum luminance of greater than or equal to about 65,000 candela per square meter ($cd/m^2$), greater than or equal to about 70,000 $cd/m^2$, greater than or equal to about 80,000 $cd/m^2$, greater than or equal to about 85,000 $cd/m^2$, greater than or equal to about 90,000 $cd/m^2$, greater than or equal to about 100,000 $cd/m^2$, or greater than or equal to about 300,000 $cd/m^2$. The maximum luminance may be less than or equal to about 5,000,000 $cd/m^2$, less than or equal to about 3,000,000 $cd/m^2$, less than or equal to about 2,000,000 $cd/m^2$, or less than or equal to about 1,000,000 $cd/m^2$.

The electroluminescent device may exhibit T50 of greater than or equal to about 90 hours, greater than or equal to about 100 hours, greater than or equal to about 150 hours, greater than or equal to about 250 hours, greater than or equal to about 261 hours, greater than or equal to about 265 hours, greater than or equal to about 270 hours, greater than or equal to about 300 hours, greater than or equal to about 350 hours, greater than or equal to about 400 hours, greater than or equal to about 480 hours, greater than or equal to about 500 hours, or greater than or equal to about 600 hours (e.g., as being measured at an initial luminance of 650 nit). The T50 may be from about 150 hours to about 2000 hours, from about 250 hours to about 1500 hours, from about 300 hours to about 1000 hours, or a combination thereof.

The electroluminescent device may exhibit a T90 of greater than or equal to about 10 hours, greater than or equal to about 20 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, or greater than or equal to about 255 hours (e.g., as being driven at an initial luminance of 650 nit). The T90 of the electroluminescent device may be from about 10 hours to about 800 hours, from about 50 hours to about 500 hours, from about 80 hours to about 300 hours, or a combination thereof.

In an embodiment, a display device or an electronic apparatus may include the electroluminescent device.

The display device or an electronic apparatus may include (or may be) an augmented reality (AR) device, a virtual reality (VR) device, a handheld terminal (e.g., device), a monitor, a notebook computer, a television, an electronic display board, a camera, an electronic display component for an automatic vehicle, or an electric car.

Disclosed herein is an electroluminescent device exhibiting a desired level of an electroluminescence property together with an increased lifespan. An electroluminescent device of an embodiment includes a zinc oxide nanoparticle in an electron transport layer, and the zinc oxide nanoparticle may exhibit an increased weight loss for example weight of a decomposed components such as organic matter, that is for example greater than 25% or greater than 32%, as determined by a Thermogravimetric analysis (TGA), and a zinc defect on a surface of the zinc oxide nanoparticle may be passivated to an increased level, for example, by a carbonate ion. The electroluminescent device of an embodiment may exhibit a reduced leakage current and a reduced hole leak, and it may maintain the initial driving voltage within a desired range.

The zinc oxide nanoparticles included in the electron transport layer of an embodiment may also be used to manufacture a panel by an inkjet process.

In an embodiment, a zinc oxide nanoparticle includes a core and a shell disposed on the core. The core of the zinc oxide nanoparticle includes $Zn_{1-x}M_xO$, wherein M is Mg, Ca, Zr, W, Li, Ti, Y, Al, or a combination thereof, and $0 \leq x \leq 0.5$, and the shell comprises an oxide layer of an alkaline earth metal, zirconium, tungsten, titanium, yttrium, aluminum, gallium, indium, tin, cobalt, vanadium, or a combination thereof.

BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a graph illustrating a full half width maximum and a half width half maximum for intensity versus binding energy in electronvolts (eV),
FIG. 2 is a schematic cross-sectional view illustrating an embodiment of a quantum dot light emitting diode ("QD-LED") device;
FIG. 3A is a schematic cross-sectional view illustrating another embodiment of a QD-LED device;
FIG. 3B is a schematic cross-sectional view illustrating another embodiment of a QD-LED device;
FIG. 3C is a schematic plane view illustrating an embodiment of a display panel;
FIG. 3D is a cross-sectional view illustrating the display panel of FIG. 3C taken along line IV-IV;
FIG. 4 is a graph illustrating the UV-Vis absorbance (arbitrary units, a.u.) versus wavelength (nanometers, nm) of the zinc oxide nanoparticle prepared in Preparation Example 1 and Preparation Example 2, as the results of an UV-Vis absorption spectroscopy analysis thereof;
Fig. 5A is a graph illustrating weight (percent, %) versus temperature (°C) for the zinc oxide nanoparticles produced in Comparative Preparation Example 1, Preparation Example 1, and Preparation Example 2, as the results of a thermogravimetric analysis thereof (i.e., TGA curves);
FIG. 5B is a graph illustrating derivative weight loss (percent per °C, %/°C) versus temperature (°C) for the zinc oxide nanoparticles prepared in Comparative Preparation Example 1, Preparation Example 1, and Preparation Example 2, as the results of a thermogravimetric analysis thereof (i.e., DTGA curves).
FIG. 6 is a graph illustrating photoluminescence intensity (a.u.) versus wavelength (nm) of the zinc oxide nanoparticles prepared in Comparative Preparation Example 1 and Preparation Example 1 as the photoluminescence analysis results (e.g., showing defect emission peaks);
FIG. 7A is a graph illustrating normalized intensity (a.u.) versus binding energy (electronvolts, eV) for the O1s XPS spectrum of the zinc oxide nanoparticles prepared in Comparative Preparation Example 1 and Preparation Example 1, as the XPS analysis results thereof;
FIG. 7B is a graph illustrating normalized intensity (a.u.) versus binding energy (electronvolts, eV) for the Zn2p1/2 XPS spectrum of the zinc oxide nanoparticles prepared in Comparative Preparation Example 1 and Preparation Example 1, as the XPS analysis results thereof;
FIG. 8 is a graph illustrating logarithmic current ($mA/cm^2$) versus voltage (volts, V) for Device Comparative Example 1, Device Example 1, and Device Example 2; and
FIG. 9 is a graph illustrating photoluminescence intensity (a.u.) versus wavelength (nm) for Experimental Example 1, as the results of a PL quenching experiment in which the photoluminescence characteristics were analyzed after each of the zinc oxide nanoparticle of Preparation Example 1 and the zinc oxide nanoparticle of Comparative Preparation Example 1 were provided on a quantum dot emission layer.

DETAILED DESCRIPTION OF THE EMBODIMENTS

Advantages and characteristics of this disclosure, and a method for achieving the same, will become evident referring to the following example embodiments together with the drawings attached hereto. However, this invention may be embodied in many different forms, the embodiments should not be construed as being limited to the embodiments set forth herein. Rather, these embodiments are provided so that this disclosure will be thorough and complete, and will fully convey the scope of the invention to those skilled in the art. Like reference numerals refer to like elements throughout.
In order to clearly explain the present disclosure, parts irrelevant to the description are omitted, and the same reference numerals are assigned to the same or similar elements throughout the specification. In the drawings, the thickness of layers, films, panels, regions, etc., are exaggerated for clarity. And in the drawings, for convenience of description, the thickness of some layers and regions are exaggerated. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above".

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as being limited to "a" or "an." "Or" means "and/or."

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

As used herein, the term "cross-sectional" means a case in which a cross-section of a given object is cut, for example, in a substantially vertical direction and is viewed laterally.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

As used herein, values of a work function, a conduction band, a valence band, a lowest unoccupied molecular orbital (LUMO), or highest occupied molecular orbital (HOMO) energy level is expressed as an absolute value from a vacuum level. In addition, when the work function or the energy level is referred to be "deep," "high" or "large," the work function or the energy level has a large absolute value based on "0 electron volts (eV)" of the vacuum level, while when the work function or the energy level is referred to be "shallow," "low," or "small," the work function or energy level has a small absolute value based on "0 eV" of the vacuum level. In an aspect, work function herein refers to a minimum energy required to remove an electron from a solid (e.g., a metal surface) to a point in a vacuum outside of the surface.

As used herein, the average (value) may be mean or median. In an embodiment, the average (value) may be a mean value.

As used herein, the term "peak emission wavelength" is the wavelength at which a given emission spectrum of the light reaches its maximum intensity.

As used herein, the term "first absorption peak" refers to a main excitonic peak appearing first from the longest wavelength region of a UV-vis absorption spectrum (i.e., appearing in the lowest energy region in the UV-Vis absorption spectrum), and the term "first absorption peak wavelength" or "wavelength of the first absorption peak" refers to the wavelength at which the first absorption peak reaches a maximum intensity.

As used herein, the term "Group" may refer to a group of the Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group IIIA metal may be Al, In, Ga, and Tl, and examples of Group IIIB may be scandium, yttrium, or the like, but are not limited thereto.

As used herein, "Group IV" refers to Group IVA and Group IVB, and examples of a Group IVA metal may be Si, Ge, and Sn, and examples of Group IVB metal may be titanium, zirconium, hafnium, or the like, but are not limited thereto.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, "metal" includes a semi-metal such as Si.

As used herein, a number of carbon atoms in a group or a molecule may be referred to as a subscript (e.g., $C_{6-50}$) or as a non-subscript (e.g., C6 to C50).

As used herein, when a definition is not otherwise provided, "substituted" refers to replacement of at least one hydrogen of a compound or a group with a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heterolaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, the wording "metal carbonate compound" may include or refer to "a metal carbonate," "a metal bicarbonate," or both.

As used herein, when a definition is not otherwise provided, "hydrocarbon" or "hydrocarbon group" refers to a compound or a group including carbon and hydrogen (e.g., alkyl, alkenyl, alkynyl, or aryl group). The hydrocarbon group may be a monovalent group or a group having a valence of greater than one formed by removal of a, e.g., one or more, hydrogen atoms from alkane, alkene, alkyne, or arene. In the hydrocarbon or hydrocarbon group, a, e.g., at least one, methylene may be replaced by an oxide moiety, a carbonyl moiety, an ester moiety, -NH-, or a combination thereof. Unless otherwise stated to the contrary, the hydrocarbon or the hydrocarbon group (alkyl, alkenyl, alkynyl, or aryl) may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl, hexyl, etc.). In an embodiment, an alkyl group may have from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having a carbon-carbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent hydrocarbon group having a carbon-carbon triple bond. In an embodiment, an alkynyl group may have from 2 to 50 carbon atoms, or 2 to 18 carbon atoms, or 2 to 12 carbon atoms.

As used herein, when a definition is not otherwise provided, "aryl" refers to a group formed by removal of a, e.g., at least one, hydrogen from an arene (e.g., a phenyl or naphthyl group). In an embodiment, an aryl group may have 6 to 50 carbon atoms, 6 to 18 carbon atoms, or 6 to 12 carbon atoms.

As used herein, when a definition is not otherwise provided, "hetero" refers to inclusion of 1 to 3 heteroatoms, e.g., N, O, S, Si, P, or a combination thereof.

As used herein, when a definition is not otherwise provided, "alkoxy" refers to an alkyl group linked to oxygen (e.g., alkyl-O-) for example, a methoxy group, an ethoxy group, or a sec-butyloxy group.

As used herein, when a definition is not otherwise provided, "amine" is a compound represented by $NR_3$, wherein each R is independently hydrogen, a C1-C12 alkyl group, a C7-C20 alkylaryl group, a C7-C20 arylalkyl group, or a C6-C18 aryl group.

As used herein, the expression "not including cadmium (or other harmful heavy metal)" may refer to the case in which a concentration of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other toxic heavy toxic metal) may be present or, if present, an amount of cadmium (or other toxic heavy metal) may be less than or equal to a detection limit of a given analysis tool (e.g., an inductively coupled plasma atomic emission spectroscopy instrument) or as an impurity level.

Unless mentioned to the contrary, a numerical range recited herein is inclusive. Unless mentioned to the contrary, a numerical range recited herein includes any real number within the endpoints of the stated range and includes the endpoints thereof. In this specification, a numerical endpoint or an upper or lower limit value (e.g., recited either as a "greater than or equal to value" "at least value" or a "less than or equal to value" or recited with "from" or "to") may be used to form a numerical range of a given feature. In other words, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$5% of the stated value.

As used herein, a nanoparticle is a structure having a, e.g., at least one, region or characteristic dimension with a nanoscale dimension. In an embodiment, a dimension (or an average dimension) of the nanostructure is less than or equal to about 500 nanometers (nm), less than or equal to about 300 nm, less than or equal to about 250 nm, less than or equal to about 150 nm, less than or equal to about 100 nm, less than or equal to about 50 nm, or less than or equal to about 30 nm, and may be greater than about 0.1 nm or about 1 nm. In an embodiment, the nanoparticle may have any suitable shape. The nanoparticle (e.g., a semiconductor nanoparticle or a metal oxide nanoparticle) may include a nanowire, a nanorod, a nanotube, a branched nanostructure, a nanotetrapod, a nanotripod, a nanobipod, a nanodot, a multi-pod type shape such as at least two pods, or the like and is not limited thereto. The nanoparticle can be substantially crystalline, substantially monocrystalline, polycrystalline, (for example, at least partially) amorphous, or a combination thereof.

In an embodiment, a semiconductor nanoparticle such as a quantum dot may exhibit quantum confinement or exciton confinement. As used herein, the term "quantum dot" or "semiconductor nanostructure" is not limited in a shape thereof unless otherwise defined. A semiconductor nanoparticle or a quantum dot may have a size smaller than a Bohr excitation diameter for a bulk crystal material having an identical composition and may exhibit a quantum confinement effect. The semiconductor nanoparticle or the quantum dot may emit light corresponding to a bandgap energy thereof by controlling a size of a nanocrystal acting as an emission center.

As used herein, the term "T50" is a time (hours, hr) taken for the brightness (e.g., luminance) of a given device to decrease to 50% of the initial brightness (100%) when the given device is initially driven, e.g., operated, at a predetermined initial brightness (e.g., 650 nit).

As used herein, the term "T90" is a time (hr) taken for the brightness (e.g., luminance) of a given device to decrease to 90% of the initial brightness (100%) when the given device is initially driven at a predetermined initial brightness (e.g., 650 nit).

As used herein, the phrase "external quantum efficiency (EQE)" is a ratio of the number of photons emitted from a light emitting device (LED) such as electroluminescence device to the number of electrons passing through the device and can be a measurement as to how efficiently a given device converts electrons to photons and allows the photons to escape. The EQE may be determined by the following equation:

EQE = (efficiency of injection) $\times$ ((solid-state) quantum yield) $\times$ (efficiency of extraction)

wherein the efficiency of injection is a proportion of electrons passing through the device that are injected into the active region, the quantum yield is a proportion of all electron-hole recombination in the active region that are radiative and produce photons, and the efficiency of extraction is a proportion of photons generated in the active region that escape from the given device.

As used herein, a maximum EQE is a greatest value of the EQE.

As used herein, a maximum luminance is the highest value of luminance for a given device.

As used herein, the phrase, quantum efficiency, may be used interchangeably with the phrase, quantum yield. In an embodiment, the quantum efficiency may be a relative quantum yield or an absolute quantum yield, for example, which can be readily measured by any suitable, e.g., commercially available, equipment. The quantum efficiency (or quantum yield) may be measured in a solution state or a solid state (in a composite). In an embodiment, "quantum yield (or quantum efficiency)" may be a ratio of photons emitted to photons absorbed, e.g., by a nanostructure or population of nanostructures. In an embodiment, the quantum efficiency may be determined by any suitable method. For example, there may be two methods for measuring the fluorescence quantum yield or efficiency: the absolute method and the relative method.

The absolute method directly obtains the quantum yield by detecting all sample fluorescence through the use of an integrating sphere. In the relative method, the fluorescence intensity of a standard sample (e.g., a standard dye) may be compared with the fluorescence intensity of an unknown sample to calculate the quantum yield of the unknown sample. Coumarin 153, Coumarin 545, Rhodamine 101 inner salt, Anthracene, and Rhodamine 6G may be used as a standard dye, depending on the photoluminescence (PL) wavelengths thereof, but are not limited thereto.

As used herein, a full width at half maximum (FWHM) is the difference between the two values of the independent variable at which the dependent variable is equal to half of its maximum value. The FWHM is the width of a spectrum curve measured between those points on the *y*-axis which are half the maximum amplitude. A half width at half maximum (HWHM) is a right half of the FWHM of a given peak (e.g., a spectrum peak). For example, the right half of the FWHM may be a width measured between the binding energy (1) at a maximum peak intensity and the binding energy (2) at a half of the maximum peak intensity in a lower energy region (see FIG. 1).

A bandgap energy of a semiconductor nanoparticle or a quantum dot may vary with a size and a composition of a nanocrystal. For example, as a size of the semiconductor nanoparticle increases, the bandgap energy of the semiconductor nanoparticle or the quantum dot may decrease, e.g., narrow, and the semiconductor nanoparticle or the quantum dot may emit light having an increased wavelength. A semiconductor nanocrystal may be used as a light-emitting material in various fields such as in, a display device, an energy device, or a bio light-emitting device.

A semiconductor nanoparticle based electroluminescent device (hereinafter, also referred to as a QD-LED) may emit light by applying a voltage and includes a semiconductor nanoparticle or a quantum dot as a light emitting material. The QD-LED is different from an organic light emitting diode (OLED) in light of a specific emission principle and may exhibit light emission with more desirable optical properties, such as higher color (e.g., red, green, and blue) purity, and improved color reproducibility and has gained attention as a material for a next generation display device. A method of producing the QD-LED may include a solution process, which may reduce manufacturing costs. In addition, a semiconductor nanoparticle in the QD-LED may be based on an inorganic material to facilitate increased display (light emission) stability over time. However, it is still desirable to develop a technology that can further improve device properties and life characteristics for the QD-LED.

In an embodiment, a structure of the QD-LED includes a light emitting layer (EML) disposed between two electrodes (e.g., an anode and a cathode), and one or more auxiliary layers (including electron transport layer (ETL) and optionally a hole transport layer (HTL)) provided on opposite surfaces of the light emitting layer, providing a charge balance and assisting an operation of a device. In an embodiment, the QD-LED may include an organic or inorganic charge auxiliary layer (e.g., an organic or inorganic hole transport layer). A QD-LED according to an embodiment may include an inorganic material (e.g., a zinc oxide nanoparticle) in an electron auxiliary layer such as an electron transport layer (ETL). In the QD-LED of an embodiment, the electron auxiliary layer containing the inorganic material on the light emitting layer may be readily formed through a solution process, for example, a relatively low-temperature (e.g., room temperature) process, and the electron auxiliary layer may provide improved mobility of electrons. A hole injected from the anode and an electron injected from the cathode may be supplied to the light emitting layer through the auxiliary layers and an exciton may be formed and light may be emitted therefrom.

In the light emitting layer, a quantum dot capable of exhibiting a practically applicable level of an electroluminescent property may include a harmful heavy metal such as cadmium (Cd), lead, mercury, or a combination thereof. Accordingly, it is desirable to provide a light emitting device or a display device having a light emitting layer substantially free of the harmful heavy metal. In a QD-LED, currently reported and satisfactory electroluminescent properties are mostly based on a cadmium-containing LED, and there is room for improvement in a QD-LED device using an environmentally-friendly quantum dot, and for example emitting blue light, that does not include cadmium or other harmful heavy metals.

In an embodiment of a QD-LED device, a zinc oxide nanoparticle prepared in the method of an embodiment and having the features described herein may be included in the electronic auxiliary layer, and accordingly, the QD-LED including a cadmium free semiconductor nanoparticle in a light-emitting layer may exhibit a desired level of an electroluminescent property and an increased lifespan.

In an embodiment, an electroluminescent device may be a device configured to emit a desired light by applying a voltage, for example, with or without a separate light source.

In an embodiment, an electroluminescent device includes a first electrode 1 and a second electrode 5 spaced apart from each other (e.g., each having a surface opposite the other, i.e., each with a surface facing the other); a light emitting layer 3 disposed between the first electrode 1 and the second electrode 5; and an electron transport layer 4 disposed between the light emitting layer 3 and the second electrode 5.

In an embodiment, a method for producing the electroluminescent device includes:

disposing (e.g., forming) a light emitting layer including a semiconductor nanoparticle (for example, a plurality of semiconductor nanoparticles) on a first electrode;
providing a zinc oxide nanoparticle;
applying a composition (e.g., a coating liquid) including the zinc oxide nanoparticle (for example, a plurality of zinc oxide nanoparticles) onto the light emitting layer to form an electron transport layer, the zinc oxide nanoparticle including a first metal; and
disposing (e.g., forming) a second electrode on the electron transport layer to produce the electroluminescent device, wherein the first metal includes an alkaline earth metal, zirconium, tungsten, titanium, yttrium, aluminum, gallium, indium, tin, cobalt, vanadium, or a combination thereof,
wherein the zinc oxide nanoparticle has a particle size of greater than or equal to about 1 nm and less than or equal to about 50 nm,
wherein the providing of the zinc oxide nanoparticle includes
contacting a precursor for the first metal (hereinafter, referred to as a first metal precursor), a zinc precursor, a base, and a metal carbonate compound in an organic solvent to form the zinc oxide nanoparticle.

The providing of the zinc oxide nanoparticle or the contacting may include dissolving the first metal precursor and the zinc precursor in the organic solvent to obtain a first solution.

The providing of the zinc oxide nanoparticles or the contacting may include adding the base and the metal carbonate compound to the organic solvent or the first solution.

The contacting may include a reaction between the zinc precursor and the first metal precursor in the presence of the base and the metal carbonate compound.

In the method of an embodiment, the composition (e.g., the coating liquid) may be a dispersion wherein the zinc oxide nanoparticle is dispersed in an organic solvent. In an embodiment, the dispersion may have a dispersed phase of a solid, and a continuous medium including a liquid. In an embodiment, the dispersion may be a colloidal dispersion in which the dispersed phase has a dimension of greater than or equal to about 1 nm, for example, greater than or equal to about 2 nm, greater than or equal to about 3 nm, greater than or equal to about 4 nm, greater than or equal to about 5 nm, or greater than or equal to about 10 nm and several micrometers ($\mu$m) or less, e.g., less than or equal to about 2 $\mu$m, less than or equal to about 1 $\mu$m, less than or equal to about 900 nm, less than or equal to about 800 nm, less than or equal to about 700 nm, less than or equal to about 600 nm, or less than or equal to about 500 nm.

In an embodiment, the electroluminescent device may further include a hole auxiliary layer 2 between the light emitting layer and the first electrode (see FIG. 2). The hole auxiliary layer may include a hole transport layer, a hole injection layer, or a combination thereof. The hole auxiliary layer may include an organic compound.

In an embodiment, the first electrode or the second electrode includes an anode or a cathode. In an embodiment, the first electrode may include an anode, and the second electrode may include a cathode. The first electrode may include a cathode and the second electrode may include an anode. In an embodiment, the second electrode includes a cathode. In an embodiment of the electroluminescent device, the first electrode 10 or the second electrode 50 may be disposed on a (transparent) substrate 100. The transparent substrate may be a light extraction surface. (see FIG. 3A and FIG. 3B). The light emitting layer may be disposed in a pixel (or a subpixel) of a display device described herein.

Referring to FIGS. 3A and 3B, in an embodiment of an electroluminescent device, a light emitting layer 30 may be disposed between a first electrode (e.g., anode) 10 and a second electrode (e.g., cathode) 50. The cathode 50 may include an electron injection conductor. The anode 10 may include a hole injection conductor. The work functions of the electron or hole injection conductors included in the cathode and the anode may be appropriately adjusted and are not particularly limited. For example, the cathode may have a relatively small work function and the anode may have a relatively large work function, or vice versa.

The electron or hole injection conductors may include a metal-containing material (e.g., a metal, a metal compound, an alloy, or a combination thereof) such as aluminum, magnesium, tungsten, nickel, cobalt, platinum, palladium, calcium, LiF, etc.; a metal oxide such as gallium indium oxide or indium tin oxide (ITO); or a conductive polymer (e.g., having a relatively high work function) such as polyethylene dioxythiophene, but are not limited thereto.

The first electrode, the second electrode, or a combination thereof may be a light-transmitting electrode or a transparent electrode. In an embodiment, both the first electrode and the second electrode may be a light-transmitting electrode. The first electrode, the second electrode, or a combination thereof may be patterned electrodes.

The first electrode, the second electrode, or a combination thereof may be disposed on a substrate 100. The substrate 100 may be an insulating substrate. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and, for example, less than or equal to about 99%, or less than or equal to about 95%). The substrate may have a transmittance of greater than or equal to about 50%, greater than or equal to about 60%, greater than or equal to about 70%, greater than or equal to about 80%, or greater than or equal to about 90% for light emitted from semiconductor nanoparticles that are described herein. The substrate 100 may include a region for a blue pixel, a region for a red pixel, a region for a green pixel, or a combination thereof. In an embodiment, a thin film (e.g., film) transistor may be disposed in each region of the substrate, but it is not limited thereto. In an embodiment, a source electrode or a drain electrode of the thin film transistor may be electrically connected to the first electrode or the second electrode.

The light transmitting or transparent electrode may be disposed on a (e.g., insulating) transparent substrate. The substrate 100 may be a rigid or a flexible substrate. The substrate may include a plastic, a glass, a metal, or a combination thereof. The substrate 100 may be a substrate including an insulating material. The substrate may include glass; various polymers such as a polyester of polyethylene terephthalate (PET), polyethylene naphthalate (PEN), and the like, polycarbonate, and polyacrylate; a polysiloxane (e.g., polydimethylsiloxane (PDMS)); an inorganic material such as $Al_2O_3$ or ZnO; or a combination thereof but is not limited thereto. A thickness of the substrate may be appropriately selected taking into consideration a substrate material but is not particularly limited.

The light-transmitting electrode may include, for example, a transparent conductor such as indium tin oxide (ITO) or indium zinc oxide (IZO), gallium indium tin oxide, zinc indium tin oxide, titanium nitride, polyaniline, LiF/Mg:Ag, or the like, or a metal thin film of a single layer or a plurality of layers, but is not limited thereto. In an embodiment, one of the first electrode or the second electrode may be an opaque electrode, the opaque electrode may include an opaque conductor such as aluminum (Al), a lithium-aluminum (Li-Al) alloy, a magnesium-silver (Mg:Ag) alloy, or lithium fluoride-aluminum (LiF:Al).

The thickness of each electrode (the first electrode, the second electrode, or both) is not particularly limited and may be appropriately selected taking into consideration device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers ($\mu$m), less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

The method of forming the electrode is not particularly limited, and can be appropriately selected taking into consideration an electrode material. In an embodiment, the electrode can be formed by deposition, coating, or a combination thereof, but is not limited thereto.

The light emitting layer 3, or 30, may be disposed between the first electrode 1 and the second electrode 5 (e.g., the anode 10 and the cathode 50). The light emitting layer may include a semiconductor nanoparticle (e.g., a plurality of semiconductor nanoparticles) such as a blue light emitting nanoparticle, a red light emitting nanoparticle, or a green light emitting nanoparticle. The light emitting layer may include one or more (e.g., 2 or more, or 3 or more, and 10 or less) monolayers of the semiconductor nanoparticle.

The light emitting layer may be patterned (not shown). In an embodiment, the patterned light emitting layer may include a blue light emitting layer disposed in the blue pixel. In an embodiment, the light emitting layer may further include a red light emitting layer disposed in the red pixel or a green light emitting layer disposed in the green pixel. In an embodiment, the light emitting layer may include a red light emitting layer disposed in the red pixel and a green light emitting layer disposed in the green pixel. Each of the (e.g., red, green, or blue) light emitting layers may be (e.g., optically) separated from an adjacent light emitting layer by a partition wall. In an embodiment, partition walls such as black matrices may be disposed between the red light emitting layer, the green light emitting layer, and the blue light emitting layer. The red light emitting layer, the green light emitting layer, and the blue light emitting layer may be optically isolated from each other.

In an embodiment, the light emitting layer 3, 30, or the semiconductor nanoparticle may not include cadmium. In an embodiment, the light emitting layer 3, 30, or the semiconductor nanoparticle may not include mercury, lead, or a combination thereof.

In an embodiment, the semiconductor nanoparticle may have a core-shell structure. In an embodiment, the semiconductor nanoparticle or the core-shell structure may include a core including a first semiconductor nanocrystal and a shell disposed on the core and including a second semiconductor nanocrystal which has a composition different from that of the first semiconductor nanocrystal.

The semiconductor nanoparticle (or the first semiconductor nanocrystal, the second semiconductor nanocrystal, or a combination thereof) may include a Group II-VI compound, a Group III-V compound, a Group IV-VI compound, a Group IV element or compound, a Group I-III-VI compound, a Group II-III-VI compound, a Group I-II-IV-VI compound, or a combination thereof. In an embodiment, the light emitting layer or the semiconductor nanoparticle (e.g., the first semiconductor nanocrystal, or the second semiconductor nanocrystal) may not include cadmium. In an embodiment, the light emitting layer, or the semiconductor nanoparticle (e.g., the first semiconductor nanocrystal or the second semiconductor nanocrystal) may not include lead. In an embodiment, the light emitting layer, or the semiconductor nanoparticle (e.g., the first semiconductor nanocrystal, or the second semiconductor nanocrystal) may not include a combination of lead and cadmium.

The Group II-VI compound may be a binary element compound such as ZnS, ZnSe, ZnTe, ZnO, HgS, HgSe, HgTe, MgSe, MgS, or a combination thereof; a ternary element compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary element compound such as HgZnTeS, HgZnSeS, HgZnSeTe, HgZnSTe, or a combination thereof; or a combination thereof. The Group II-VI compound may further include a Group III metal.

The Group III-V compound may be a binary element compound such as GaN, GaP, GaAs, GaSb, AlN, AlP, AlAs, AlSb, InN, InP, InAs, InSb, or a combination thereof; a ternary element compound such as GaNP, GaNAs, GaNSb,

GaPAs, GaPSb, AlNP, AlNAs, AlNSb, AlPAs, AlPSb, InNP, InNAs, InNSb, InPAs, InPSb, or a combination thereof; a quaternary element compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof; or a combination thereof. The Group III-V compound may further include a Group II metal (e.g., InZnP).

The Group IV-VI compound may be a binary element compound such as SnS, SnSe, SnTe, PbS, PbSe, PbTe, or a combination thereof; a ternary element compound such as SnSeS, SnSeTe, SnSTe, PbSeS, PbSeTe, PbSTe, SnPbS, SnPbSe, SnPbTe, or a combination thereof; a quaternary element compound such as SnPbSSe, SnPbSeTe, SnPbSTe, or a combination thereof; or a combination thereof.

Examples of the Group I-III-VI compound may be $CuInSe_2$, $CuInS_2$, CuInGaSe, and CuInGaS, but are not limited thereto. Examples of the Group I-III-VI compound may include a ternary element compound such as AgInS, $AgInS_2$, $AgInSe_2$, AgGaS, $AgGaS_2$, $AgGaSe_2$, CuInS, $CuInS_2$, $CuInSe_2$, $CuGaS_2$, $CuGaSe_2$, $CuGaO_2$, $AgGaO_2$, $AgAlO_2$ or a combination thereof; a quaternary element compound such as $AgInGaS_2$, $AgInGaSe_2$, or a combination thereof; or a combination thereof.

Examples of the Group I-II-IV-VI compound may be CuZnSnSe, and CuZnSnS, but are not limited thereto.

The Group IV element or compound may include a single element (elementary substance) such as Si, Ge, or a combination thereof; a binary element compound such as SiC, SiGe, or a combination thereof; or a combination thereof.

Each element included in a multi-element compound such as a binary element compound, a ternary element compound, or a quaternary element compound may be present in the particle at a uniform concentration or at a nonuniform concentration. For example, the chemical formula described above means the types of elements included in the compound, and the ratio among the elements in the compound may be different. For example, the chemical formula "$AgInGaS_2$" may include $AgIn_xGa_{1-x}S_2$ (x is a real number of greater than 0 and less than or equal to 1), but is not limited thereto.

In an embodiment, the first semiconductor nanocrystal may include a metal including indium, zinc, or a combination thereof, and a non-metal including phosphorus, selenium, tellurium, sulfur, or a combination thereof. In an embodiment, the second semiconductor nanocrystal may include a metal including indium, zinc, or a combination thereof, and a non-metal element including phosphorus, selenium, tellurium, sulfur, or a combination thereof.

In an embodiment, the first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof. In an embodiment, the shell may include zinc, sulfur, and optionally selenium for example in the outermost layer.

In an embodiment, the semiconductor nanoparticle may emit blue or green light and may include a core including ZnSeTe, ZnSe, or a combination thereof, and a shell including a zinc chalcogenide (e.g., ZnS, ZnSe, ZnSeS, or a combination thereof). An amount of sulfur in the shell may increase or decrease in a radial direction (from the core toward the surface), e.g., the amount of sulfur may have a concentration gradient wherein the concentration of sulfur varies radially (e.g., decreases or increases in a direction toward the core).

In an embodiment, the semiconductor nanoparticle may emit red or green light, the core may include InP, InZnP, or a combination thereof, and the shell may include a Group II metal including zinc and a non-metal including sulfur, selenium, or a combination thereof. The semiconductor nanoparticle may include a first semiconductor nanocrystal including zinc, selenium, and tellurium, and a second semiconductor nanocrystal different from the first semiconductor nanocrystal.

The semiconductor nanoparticle may include a first semiconductor nanocrystal including indium, phosphorus, and optionally zinc; and a second semiconductor nanocrystal including a zinc chalcogenide and being different from the first semiconductor nanocrystal. The semiconductor nanoparticle may include a zinc chalcogenide. The zinc chalcogenide may include tellurium. The semiconductor nanoparticle may be configured to emit blue light or green light. The semiconductor nanoparticle may include a core including the first semiconductor nanocrystal and a shell disposed on the core and including the second semiconductor nanocrystal.

In an embodiment, the semiconductor nanoparticle may have a core-shell structure, and on the interface between the core and the shell, an alloyed interlayer may be present or may not be present. The alloyed interlayer may include a homogeneous alloy or may have a concentration gradient. The gradient alloy may have a concentration gradient wherein the concentration of an element of the shell varies radially (e.g., decreases or increases in a direction toward the core).

In an embodiment, the shell may have a composition that varies in a radial direction. In an embodiment, the shell may be a multilayered shell including two or more layers. In a multilayered shell, adjacent two layers may have different compositions from each other. In a multilayered shell, a, e.g., at least one, layer may independently include a semiconductor nanocrystal having a single composition. In a multilayered shell, a, e.g., at least one, layer may independently have an alloyed semiconductor nanocrystal. In a multilayered shell, a, e.g., at least one, layer may have a concentration gradient that varies radially in terms of a composition of a semiconductor nanocrystal.

In an embodiment, in the semiconductor nanoparticle having a core-shell structure, a shell material may have a bandgap energy that is greater than that of the core. The materials of the shell may have a bandgap energy that is less than that of the core. In the case of a multilayered shell, the bandgap energy of the outermost layer material of the shell may be greater than the bandgap energies of the core and the inner layer material of the shell (layers that are closer to the core). In the case of a multilayered shell, a semiconductor nanocrystal of each layer is selected to have an appropriate bandgap, thereby effectively exhibiting a quantum confinement effect.

The semiconductor nanoparticle according to an embodiment may include, for example, an organic ligand which is bonded or coordinated to a surface thereof.

An absorption or emission wavelength of the semiconductor nanoparticle may be controlled by adjusting the compositions, sizes, or a combination thereof, of the semiconductor nanoparticle. The semiconductor nanoparticle included in the light emitting layer 3, or 30, may be configured to emit light of a desired color. The semiconductor nanoparticle may include a blue light emitting semiconductor nanoparticle, a green light emitting semiconductor nanoparticle, or a red light emitting semiconductor nanoparticle.

In an embodiment, a peak emission wavelength of the semiconductor nanoparticle or a light emission layer (or the light emitted from the electroluminescent device) may be in a wavelength range of from ultraviolet to infrared. In an embodiment, the peak emission wavelength of the semiconductor nanoparticle or the light emitting layer (or the light emitted from the electroluminescent device) may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The peak emission wavelength may be less than or equal to about 900 nm, less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The peak emission wavelength may be from about 500 nm to about 650 nm.

The semiconductor nanoparticle, the light emitting layer, or the electroluminescent device may emit green light (for example, on an application of a voltage or irradiation with light) and a peak emission wavelength thereof may be in the range of greater than or equal to about 500 nm (for example, greater than or equal to about 510 nm, or greater than or equal to about 515 nm) and less than or equal to about 560 nm, for example, less than or equal to about 540 nm, or less than or equal to about 530 nm.

The semiconductor nanoparticle, the light emitting layer, or the electroluminescent device may emit red light (for example, on an application of voltage or irradiation with light), and a peak emission wavelength thereof may be in the range of greater than or equal to about 600 nm, for example, greater than or equal to about 610 nm and less than or equal to about 650 nm, or less than or equal to about 640 nm.

The semiconductor nanoparticle, the light emitting layer, or the electroluminescent device may emit blue light (for example, on an application of voltage or irradiation with light), and a peak emission wavelength thereof may be greater than or equal to about 430 nm (for example, greater than or equal to about 450 nm, greater than or equal to about 455 nm, greater than or equal to about 460 nm, or greater than or equal to about 465 nm) and less than or equal to about 480 nm (for example, less than or equal to about 475 nm, less than or equal to about 470 nm, or less than or equal to about 465 nm).

In an embodiment, the semiconductor nanoparticle, the light emitting layer, or the electroluminescent device may exhibit a luminescent spectrum (e.g., photo- or electro- luminescent spectrum) with a relatively narrow full width at half maximum. In an embodiment, in the photo- or electro- luminescent spectrum, the semiconductor nanoparticle, the light emitting layer, or the electroluminescent device may exhibit a full width at half maximum of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm. The full width at half maximum may be greater than or equal to about 10 nm, greater than or equal to about 15 nm, greater than or equal to about 20 nm, or greater than or equal to about 25 nm.

The semiconductor nanoparticle may exhibit (or may be configured to exhibit) a quantum efficiency (or quantum yield) of greater than or equal to about 10%, for example, greater than or equal to about 30%, greater than or equal to about 50%, greater than or equal to about 60%, greater than or equal to about 70%, greater than or equal to about 80%, greater than or equal to about 90%, or about 100%.

The semiconductor nanoparticle may have a size (or an average size, hereinafter, can be simply referred to as "size") of greater than or equal to about 1 nm and less than or equal to about 100 nm. The size may be a diameter or equivalent diameter converted by assuming a spherical shape from an electron microscope image when not spherical. The size may be calculated by using a result of an inductively coupled plasma atomic emission spectroscopy (ICP-AES) analysis. In an embodiment, the semiconductor nanoparticle may have a size of from about 1 nm to about 50 nm, for example, from about 2 nm (or about 3 nm) to about 35 nm. In an embodiment, a size (or an average size) of the semiconductor nanoparticle may be greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, or greater than or equal to about 12 nm. In an embodiment, a size (or an average size) of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, or less than or equal to about 12 nm.

A shape of the semiconductor nanoparticle or the semiconductor nanostructure is not particularly limited. For example, the shape of the semiconductor nanoparticle may include, but is not limited to, a sphere, a polyhedron, a pyramid, a multi-pod shape, a hexahedron, a cube, a cuboid, a nanotube, a nanorod, a nanowire, a nanosheet, or a combination thereof.

The semiconductor nanoparticle may be prepared in an appropriate method. The semiconductor nanoparticle may be prepared for example by a chemical wet method wherein a nanocrystal particle may grow by a reaction between precursors in a reaction system including an organic solvent and an organic ligand. The organic ligand or the organic solvent may coordinate with or to a surface of the semiconductor nanocrystal to control the growth thereof.

In an embodiment, for example, the method of preparing the semiconductor nanoparticle having a core/shell structure may include obtaining the core; reacting a first shell precursor including a metal (e.g., zinc) and a second shell precursor including a non-metal element (e.g., selenium, sulfur, or a combination thereof) in the presence of the core in a reaction medium including an organic ligand and an organic solvent at a reaction temperature (e.g., of greater than or equal to about 180 °C, greater than or equal to about 200 °C, greater than or equal to about 240 °C, or greater than or equal to about 280 °C and less than or equal to about 360°C, less than or equal to about 340 °C, or less than or equal to about 320 °C) to form a shell including a second semiconductor nanocrystal on a core including a first semiconductor nanocrystal. The method may further include separating a core from a reaction system producing the same and dispersing the core in an organic solvent to obtain a core solution.

In an embodiment, in order to form the shell, a solvent and optionally, the first shell precursor and a ligand compound may be heated at a predetermined temperature (e.g., greater than or equal to about 100 °C) under vacuum (also referred to herein as vacuum-treated) and then, after introducing an inert gas into the reaction vessel, the mixture may be heat-treated again at a predetermined temperature (e.g., greater than or equal to 100 °C). Then, the core and the second shell precursor may be added to the mixture and heated at a reaction temperature. The shell precursors may be added at different ratios during a reaction time simultaneously or sequentially.

In the semiconductor nanoparticle of an embodiment, the core may be prepared in an appropriate manner. In an embodiment, the organic solvent may include a C6 to C22 primary amine such as a hexadecylamine, a C6 to C22 secondary amine such as dioctylamine, a C6 to C40 tertiary amine such as a trioctyl amine, a nitrogen-containing heterocyclic compound such as pyridine, a C6 to C40 olefin such as octadecene, a C6 to C40 aliphatic hydrocarbon such as hexadecane, octadecane, or squalane, an aromatic hydrocarbon substituted with a C6 to C30 alkyl group such as phenyldodecane, phenyltetradecane, or phenyl hexadecane, a primary, secondary, or tertiary phosphine (e.g., trioctyl phosphine) substituted with a, e.g., at least one (e.g., 1, 2, or 3), C6 to C22 alkyl group, a phosphine oxide (e.g., trioctylphosphine oxide) substituted with a (e.g., 1, 2, or 3) C6 to C22 alkyl group, a C12 to C22 aromatic ether such as phenyl ether or benzyl ether, or a combination thereof. A combination including more than one type of organic solvent may be used.

The organic ligand may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', $RPO(OH)_2$, $R_2POOH$ or a combination thereof. Herein, R and R' are each independently a substituted or unsubstituted, C3 or greater, C6 or greater, or C10 or greater and C40 or less, C35 or less, or C25 or less, aliphatic hydrocarbon group (e.g., alkyl, alkenyl, alkynyl, etc.), a substituted or unsubstituted C6 to C40 aromatic hydrocarbon group (e.g., aryl group), or a combination thereof. In an embodiment, at least two different organic ligands may be used.

Examples of the organic ligand may be a thiol compound such as methane thiol, ethane thiol, propane thiol, butane thiol, pentane thiol, hexane thiol, octane thiol, dodecane thiol, hexadecane thiol, octadecane thiol, benzyl thiol, and the like; amines such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, trioctylamine, and the like; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, myristic acid, stearic acid, lauric acid, benzoic acid, and the like; a phosphine compound such as methyl phosphine, ethyl phosphine, propyl phosphine, butyl phosphine, pentyl phosphine, octylphosphine, dioctyl phosphine, tributylphosphine, trioctylphosphine, and the like; a phosphine oxide compound thereof such as methyl phosphine oxide, ethyl phosphine oxide, propyl phosphine oxide, butyl phosphine oxide, pentyl phosphineoxide, tributylphosphineoxide, octylphosphine oxide, dioctyl phosphineoxide, trioctylphosphineoxide, and the like;

diphenyl phosphine (DPP), triphenyl phosphine compound or an oxide compound thereof; C5 to C20 alkyl phosphinic acid such as hexylphosphinic acid, octylphosphinic acid, dodecanephosphinic acid, tetradecanephosphinic acid, hexadecanephosphinic acid, octadecanephosphinic acid; C5 to C20 alkyl phosphonic acid; and the like, but is not limited thereof.

The semiconductor nanoparticle may be recovered by a process of pouring a non-solvent into a mixture including the semiconductor nanoparticle and subjecting the mixture to a centrifugation in order to remove excess organic substance that is not coordinated on the surface from them. For example, in an embodiment, after completing the reaction (for the formation of the core or for the formation of the shell), a non-solvent may be added to a reaction mixture and the semiconductor nanoparticle coordinated with the ligand compound may be separated therefrom. The non-solvent may be a polar solvent that is miscible with the solvent used in the core formation reactions, shell formation reaction, or a combination thereof, and is not capable of dispersing the prepared semiconductor nanoparticles. The non-solvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing non-solvents, or a combination thereof. The semiconductor nanoparticles may be separated through centrifugation, sedimentation, or chromatography. The separated semiconductor nanoparticles may be washed with a washing solvent, if desired. The washing solvent has no particular limit and may have a similar solubility parameter to that of the ligand and may, for example, include hexane, heptane, octane, chloroform, toluene, benzene, and the like.

The semiconductor nanoparticles of an embodiment may be non-dispersible or insoluble in water, the aforementioned non-solvent, or a combination thereof. The semiconductor nanoparticles of an embodiment may be dispersed in the aforementioned organic solvent. In an embodiment, the aforementioned semiconductor nanoparticles may be dispersed in a substituted or unsubstituted C6 to C40 aliphatic hydrocarbon, a substituted or unsubstituted C6 to C40 aromatic hydrocarbon, or a combination thereof.

In an embodiment of the electroluminescent device or the display device, a thickness of the light emitting layer may be appropriately selected. In an embodiment, the light emitting layer may include a monolayer of nanoparticles. In an embodiment, the light emitting layer may include one or more, for example, two or more, three or more, or four or more and 20 or less, 10 or less, 9 or less, 8 or less, 7 or less, or 6 or less monolayers of semiconductor nanoparticles. The light emitting layer may have a thickness of greater than or equal to about 5 nm, for example, greater than or equal to about 10 nm, greater than or equal to about 20 nm, or greater than or equal to about 30 nm and less than or equal to about 200 nm, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer may have a thickness of, for example, about 10 nm to about 150 nm, about 20 nm to about 100 nm, or about 30 nm to about 50 nm.

In an embodiment, the disposing (e.g., forming) of the light emitting layer 3 including the semiconductor nanoparticle may be performed by providing a composition including a semiconductor nanoparticle and an organic solvent and applying or depositing the same on a substrate (e.g., an electrode) or a charge auxiliary layer (e.g., a hole auxiliary layer or electron auxiliary layer) in an appropriate manner (e.g., by spin coating, inkjet printing, etc.).

The formed film of the semiconductor nanoparticle may be further subjected to contacting, an organic solution, for example, a metal halide (e.g., zinc chloride) organic solution (e.g., an alcohol solution).

The forming of the light emitting layer may further include heat-treating the coated or deposited semiconductor nanoparticle layer. The heat-treating temperature is not particularly limited, and it can be appropriately selected taking into consideration the boiling point of the organic solvent. For example, the heat treatment temperature may be greater than or equal to about 60°C. A type of the organic solvent for dispersing the semiconductor nanoparticle is not particularly limited and may be selected appropriately. In an embodiment, the organic solvent may include a substituted or unsubstituted aliphatic hydrocarbon organic solvent, a substituted or unsubstituted aromatic hydrocarbon solvent, a substituted or unsubstituted alicyclic hydrocarbon solvent, an acetate solvent, or a combination thereof.

In an embodiment, the light emitting layer may be a single layer or a multi-layered structure having at least two layers. In the multi-layered structure, adjacent layers (e.g., a first light emitting layer and a second light emitting layer) may be configured to emit a first light (e.g., green light, blue light, or red light). In the multi-layered structure, adjacent layers (e.g., a first light emitting layer and a second light emitting layer) may have the same or different composition, ligands, or a combination thereof. In an embodiment, the (multi-layered) light emitting layer may have a halogen amount that varies (increase or decrease) in a thickness direction. In an embodiment, in the (multi-layered) light emitting layer, the amount of the halogen may increase in a direction toward the electron auxiliary layer. In the (multi-layered) light emitting layer, an amount, or a content of an organic ligand may decrease in the direction toward the electron auxiliary layer. In the (multi-layered) light emitting layer, the amount, or the content of the organic ligand may increase in the direction toward the electron auxiliary layer.

In an embodiment, the light emitting layer may include a first light emitting layer including a first semiconductor nanoparticle and a second light emitting layer including a second semiconductor nanoparticle, wherein the first semiconductor nanoparticle has a halogen (e.g., chlorine) exchanged surface and the second light emitting layer has a greater amount of an organic ligand than the first light emitting layer. A halogen (e.g., chlorine) amount and an organic ligand amount of the light emitting layer may be controlled with an appropriate manner (e.g., a post treatment for the formed layer). In an embodiment, a thin film of the semiconductor nanoparticles having an organic ligand (e.g., having a carboxylic acid group) is formed, which is then treated with a solution including a metal halide (e.g., a zinc halide such as a zinc chloride in alcohol solvent) to control (decrease) an amount of the organic ligand of the semiconductor nanoparticles in the thin film. The treated thin film may have an increased halogen amount exhibiting a changed property (e.g., solubility) with respect to an organic solvent, and it may be possible to form a layer of semiconductor nanoparticles having a different amount of an organic ligand (e.g., a halogen treated semiconductor nanoparticle or a semiconductor nanoparticle with a ligand having a carboxylic acid group) on the treated thin film, subsequently.

An electron auxiliary layer 4, or 40, may be disposed on the light emitting layer 3, or 30, for example, between the light emitting layer and the second electrode 5, or 50. In the electron auxiliary layer 4, or 40, transporting, injecting, or transporting and injecting of electrons may occur. The electron auxiliary layer 4, or 40, includes an electron transport layer (ETL). The electron auxiliary layer 4, or 40, may further include an electron injection layer, a hole blocking layer, or a combination thereof. The electron injection layer may be disposed between the electron transport layer and the second electrode, the hole blocking layer may be disposed between the electron transport layer and the light emitting layer, but they are not limited thereto. The electron transport layer may be adjacent to (e.g., directly adjacent to, or directly disposed on) the light emitting layer. In an embodiment, the light emitting layer 3, or 30, may contact the electron transport layer.

The electron transport layer may include a zinc oxide nanoparticle (e.g., a plurality of zinc oxide nanoparticles). The zinc oxide nanoparticle may further include a first metal different from zinc. The zinc oxide nanoparticle may have a size or an average size (hereinafter, simply referred to as "size") of greater than or equal to about 1 nm and less than or equal to about 50 nm. The first metal may include an alkaline earth metal (e.g., magnesium, calcium, barium, strontium, or a combination thereof), zirconium (Zr), tungsten (W), titanium (Ti), yttrium (Y), aluminum (Al), gallium (Ga), indium (In), tin (Sn), cobalt (Co), vanadium (V), or a combination thereof. The first metal may include an alkaline earth metal and the first metal may further include or may not include zirconium (Zr), tungsten (W), titanium (Ti), yttrium (Y), aluminum (Al), gallium (Ga), indium (In), tin (Sn), cobalt (Co), vanadium (V), or a combination thereof. The zinc oxide nanoparticle may further include or may not include alkali metal. The zinc oxide nanoparticle or the alkali metal may include sodium, potassium, rubidium, cesium, francium, or a combination thereof. The zinc oxide nanoparticle or the alkali metal may include or may not include lithium.

An electron auxiliary layer based on a zinc oxide nanoparticle may be provided for a cadmium-containing QD-LED. However, the present inventors have found that despite the use of the electron auxiliary layer based on the zinc oxide nanoparticles, there may be a technological limit to improving both an electroluminescent property and life-span simultaneously, in the case of an electroluminescent device including a cadmium-free semiconductor nanoparticle that is configured to emit light of a desired wavelength (e.g., blue light) in a light emitting layer.

Without wishing to be bound by theory, it is believed that in QD-LEDs with a light emitting layer containing non-cadmium-containing semiconductor nanoparticles (for example, a blue-light emitting semiconductor nanoparticle containing a zinc chalcogenide core), a charge imbalance between the holes moving through the hole auxiliary layer (e.g., a HTL) and the electrons moving through a zinc oxide nanoparticle-containing ETL may occur, and the charge imbalance may lead to a decrease in an electroluminescence property (e.g., a maximum external quantum efficiency or a maximum luminance) of the light emitting device or deterioration of the device.

The QD-LED may include a zinc oxide nanoparticle in an electron transport layer, and the zinc oxide nanoparticle can be synthesized through a bottom-up process or a solution-precipitation process. The present inventors have found that the method of manufacturing the zinc oxide nanoparticle may affect a particle size, an amount of a surface organic matter, and a surface defect passivation, ultimately being able to affect the characteristics of an electroluminescent device (e.g., QD-LED) including such an ETL. The present inventors have found that in zinc oxide-containing ETL materials, a defect includes various types, such as a Zn interstitial (Zni) and oxygen vacancy (Vo), and with a currently known method it is difficult to control them in a desired way. In this regard, there has been an attempt to provide an electron transport layer by adding an alkali metal carbonate to a pristine solution containing a precursor and a stabilizer to form a zinc oxide layer according to a sol-gel method. The present inventors have found that in this type of art, the formation of a zinc oxide nanoparticle of a desired size may not be guaranteed, and there is a limitation to performance improvement of the QD-LED including the ETL thus prepared. The zinc oxide nanoparticle prepared with a known method may exhibit a dispersibility for only a limited type of solvent (e.g., ethanol). In order to form an electron transport layer on an emission layer by an inkjet printing method, it may be desired that the composition for providing the ETL exhibits physical properties suitable for the inkjet printing method. The present inventors have also found that a composition containing zinc oxide nanoparticles manufactured according to conventional technology tends to block an ink nozzle. Without wishing to be bound by theory, it is believed that a solvent such as ethanol can be vaporized relatively quickly under the inkjet printing condition, and accordingly, an ethanol composition containing the zinc oxide nanoparticles according to the conventional art has less stability over time, and this can limit its use for production of a light emitting device via an inkjet printing manner.

The present inventors have also found that the zinc metal oxide nanoparticles manufactured by the bottom-up-based process may have an organic material derived from a reagent contained in a reaction system such as a precursor as a particle surface stabilization ligand, but still may include a considerable level of various surface defects. With a known method to date, it may be difficult to achieve additional surface passivation in the prepared zinc oxide nanoparticles. Without wishing to be bound by theory, it is believed that the surface properties of the zinc oxide nanoparticle may affect the physical properties of the electroluminescent device, causing for example, a decrease in efficiency and deterioration of the electron transport layer.

The present inventors have found that the method of an embodiment described herein may achieve a passivation in a different manner from the conventional art. Without wishing to be bound by theory, it is believed that according to the method of an embodiment, in addition to the surface passivation provided by the organic acid-derived ligand and the hydroxyl ligand derived from the precursor, direct surface passivation by the binding of carbonate may be provided. Without wishing to be bound by theory, it is believed that due to the surface passivation occurring in the zinc oxide nanoparticle prepared by the method of an embodiment, the features described here can be identified (e.g., in the aspect of the spectrum identified by XPS). The zinc oxide nanoparticle of an embodiment or the electron transport layer containing the same may exhibit the component spectrum (e.g., O1s spectrum, etc.) as determined by an XPS analysis and the TGA analysis result (e.g., differential thermogravimetric analysis curve, etc.) as described herein

Surprisingly, the present inventors have found that the electroluminescent device including the electron transport layer including the zinc oxide nanoparticles of an embodiment may exhibit an extended lifespan together with improved optical properties.

In an embodiment, the providing of the zinc oxide nanoparticle includes contacting a first metal precursor, a zinc precursor, a base, and a metal carbonate compound in an organic solvent to form the zinc oxide nanoparticle. In an embodiment, the providing of the zinc oxide nanoparticle may include dissolving the first metal precursor and the zinc precursor in an organic solvent, and adding a base and a metal carbonate compound to the organic solvent and allowing the zinc precursor and the first metal precursor (e.g., at a first temperature) to react to form the zinc oxide nanoparticles.

The first metal may include an alkaline earth metal (e.g., magnesium). The first metal may include zirconium, tungsten, titanium, yttrium, aluminum, gallium, indium, tin, cobalt, vanadium, or a combination thereof. The first metal may include magnesium; and optionally zirconium, tungsten, titanium, yttrium, aluminum, gallium, indium, tin, cobalt, vanadium, or a combination thereof. The first metal may include magnesium and gallium. The zinc oxide nanoparticles may further include or may not include alkali metal. The zinc oxide nanoparticle or the alkali metal may include or may not include lithium, sodium, potassium, rubidium, cesium, francium, or a combination thereof.

The organic solvent may include a C1 to C10 alcohol solvent, dimethyl sulfoxide, a substituted or unsubstituted C1 to C30 or C3 to C15 hydrocarbon solvent (e.g., a substituted or unsubstituted aliphatic hydrocarbon, a substituted or unsubstituted aromatic hydrocarbon, a substituted or unsubstituted alicyclic hydrocarbon or a combination thereof), or a combination thereof. The organic solvent may include a C1 to C10 alcohol solvent (e.g., methanol, ethanol, propanol, isopropanol, butanol, isobutanol, pentanol, isopentanol, or a combination thereof), a sulfoxide solvent (e.g., dimethyl sulfoxide), a C3 to C15 hydrocarbon solvent (e.g., an aliphatic, aromatic, alicyclic solvent, or an alicyclic compound obtained by a hydrogen addition reaction of aromatic hydrocarbons), or a combination thereof.

The organic solvent may include a first solvent, a second solvent, or a mixture thereof. In an embodiment, the organic solvent may be a solvent mixture including a first solvent and a second solvent, and a relative polarity difference between the first solvent and the second solvent may be greater than or equal to about 0.3 and less than or equal to about 0.9. The method may further include stirring a mixture of the first solvent and the second solvent, for example, at a predetermined temperature (e.g., at a temperature of greater than or equal to about 40°C and less than or equal to about 80°C).

By using the mixed solvent, the synthesis of the zinc oxide nanoparticle may involve a phase transition and separation mechanism (e.g., liquid-solid-solution synthesis, LSS synthesis) which occurs at the interface of liquid, solid, and solution phases present during the synthesis. Without wishing to be bound by theory, it is believed that in the method of an embodiment, a nanobubble (e.g., a solution bubble or a liquid bubble) may readily form in the solvent mixture including the first solvent and the second solvent due to the polarity difference between the first solvent and the second solvent, and a movement (e.g., a phase transfer and/or a phase separation) and a reaction of precursors (solid) may occur at an interface between the solvent mixture and the formed nanobubble to form an oxide nanoparticle including magnesium and zinc (e.g., a first nanoparticle). The zinc oxide nanoparticles thus formed may further react with an additional metal precursor (for example, a gallium precursor) as described below, and may more readily form a zinc oxide nanoparticle having a core-shell structure.

A difference between the relative polarities of the first solvent and the second solvent may be greater than or equal to about 0.35, greater than or equal to about 0.4, greater than or equal to about 0.45, greater than or equal to about 0.5, or greater than or equal to about 0.55. The difference between the relative polarities may be less than or equal to about 3, less than or equal to about 2, less than or equal to about 1, less than or equal to about 0.85, less than or equal to about 0.8, less than or equal to about 0.75, less than or equal to about 0.7, less than or equal to about 0.65, less than or equal to about 0.6, less than or equal to about 0.55, less than or equal to about 0.5, or less than or equal to about 0.45. The relative polarity of the solvents may be obtained from the literature (e.g., Solvents and solvent effects in organic chemistry, Wiley VCH publisher, 3rd edition, 2003). For example, water has a relative polarity of about 1.

The first solvent may include a C1 to C10 alcohol solvent, for example, methanol, ethanol, propanol, isopropanol, butanol, isobutanol, pentenol, isopentenol, or a combination thereof. The first solvent may have relative polarity of greater than or equal to about 0.4, greater than or equal to about 0.45, greater than or equal to about 0.5, greater than or equal to about 0.55, greater than or equal to about 0.6, greater than or equal to about 0.65, greater than or equal to about 0.7, or greater than or equal to about 0.75. The relative polarity of the first solvent may be less than or equal to about 2, less than or equal to about 1, or less than or equal to about 0.9.

The second solvent may include a C3 to C15 hydrocarbon solvent (aliphatic, aromatic, alicyclic, or hydrocarbon solvents including a hydrogenated benzene ring, for example, cyclohexane, hexane, heptane, nonane, octane, etc.). The second solvent may have a relative polarity of greater than or equal to about 0.001, greater than or equal to about 0.003, greater than or equal to about 0.006, greater than or equal to about 0.009, greater than or equal to about 0.01, or greater than or equal to about 0.012. The relative polarity of the second solvent may be less than or equal to about 4, less than or equal to about 3.5, less than or equal to about 3, less than or equal to about 2.5, less than or equal to about 2, less than or equal to about 1.5, less than or equal to about 1, less than or equal to about 0.5, less than or equal to about 0.1, less than or equal to about 0.05, or less than or equal to about 0.01.

In an embodiment, the second solvent may form a nanobubble in the first solvent. In an embodiment, the first solvent may form a nanobubble in the second solvent. A volume ratio of the second solvent to the first solvent (second solvent: first solvent) may be from about 1:0.2 to about 1:5, from about 1:0.3 to about 1:3, from about 1:0.5 to about 1:2, from about 1:0.8 or about 1:1.25, from about 1:1 to about 1:1.5, or a combination thereof. In an embodiment, an amount of the first solvent may be greater than an amount of the second solvent. In an embodiment, an amount of the first solvent may be less than an amount of the second solvent.

The stirring of the solvent mixture may be performed at a speed of greater than or equal to about 100 revolutions per minute (rpm), greater than or equal to about 150 rpm, greater than or equal to about 200 rpm, greater than or equal to about 250 rpm, greater than or equal to about 300 rpm, greater than or equal to about 350 rpm, greater than or equal to about 400 rpm, greater than or equal to about 450 rpm, or greater than or equal to about 500 rpm. The stirring may be performed at a speed of less than or equal to about 800 rpm, less than or equal to about 700 rpm, or less than or equal to about 600 rpm. The predetermined temperature may be greater than or equal to about 40 °C, for example, greater than or equal to about 50 °C, or greater than or equal to about 55 °C. The predetermined temperature may be less than or equal to about a boiling point of the first solvent (or less than or equal to about a boiling point of the second solvent), less than or equal to about 78 °C, less than or equal to about 70 °C, less than or equal to about 65 °C, or less than or equal to about 60 °C.

The organic solvent (or the composition for forming ETL described herein) may not contain butylamine, ethylamine, ethanolamine, hexamethylene diamine, aniline, hexylamine, or a combination thereof. The organic solvent (or the composition for forming ETL described below) may not contain C1 to C12 organic amine, an aromatic amine having a benzene group, or a combination thereof. The organic amine may be ethylamine, butylamine, hexamethylene diamine, aniline, or ethanolamine.

The zinc precursor may include an organic compound including zinc, and the first metal precursor may include an organic compound including a first metal. The first metal precursor may further include or may not include an alkali metal. Details of the first metal and the alkali metal are the same as described herein. In an embodiment, the first metal may include magnesium. In an embodiment, the first metal may be magnesium.

The zinc precursor and the first metal precursor may include a carboxylate moiety (e.g., an acetate moiety).

The zinc precursor may include a zinc carboxylate such as zinc acetylacetonate, a zinc acetate, a zinc halide (a zinc chloride, a zinc bromide, a zinc iodide, a zinc fluoride, etc.), a zinc nitrate, a zinc oxide, or a combination thereof.

The first metal precursor (e.g., which may include magnesium, gallium, etc.) may include a compound (e.g., an organic compound), for example a carboxylate compound (acetate), an acetylacetonate compound, a halide, a nitrogen compound such as a nitride or a nitrate, an oxide, or a combination thereof. In an embodiment, the first metal precursor may include a magnesium carboxylate (e.g., magnesium acetate), magnesium acetylacetonate, a magnesium halide (magnesium chloride, magnesium bromide, magnesium fluoride, magnesium iodide), magnesium nitrate, magnesium oxide, or a combination thereof. In an embodiment, the precursor for the first metal (or additional metals described below) may include a gallium acetate, a gallium acetylacetonate, a gallium carboxylate, a gallium halide, a gallium nitride, a gallium oxide, or a combination thereof. In an embodiment, the halide may include a chloride, a fluoride, a bromide, or an iodide.

The zinc oxide nanoparticles obtained by the method may include a first metal and an alkali metal, and may exhibit the optical properties described herein. The molar ratio between the zinc precursor and the first metal precursor may be appropriately selected in consideration of the desired composition of the zinc oxide nanoparticles. In an embodiment, the molar ratio of the first metal precursor per 1 mole of the zinc precursor may be from about 0.1 to 1.5 moles, about 0.2 to 1 mole, about 0.3 to 0.9 moles, about 0.4 to 0.8 moles, about 0.5 moles, or a combination thereof.

In an embodiment, a metal carbonate compound and a base may be added to the organic solvent (or a solution obtained by dissolving the first metal precursor and the zinc precursor in the organic solvent) and the zinc precursor and the first metal precursor may be allowed to react together.

The metal carbonate compound may include an alkali metal carbonate, an alkali metal bicarbonate, an alkaline earth metal carbonate, or a combination thereof. The metal carbonate compound may include sodium, potassium, rubidium, cesium, francium, or a combination thereof. The metal carbonate compound may be an alkali metal carbonate compound. The metal carbonate compound may include lithium carbonate, sodium carbonate, potassium carbonate, rubidium carbonate, cesium carbonate, or a combination thereof. In an embodiment, the metal carbonate compound may include a metal (e.g., cesium or rubidium) having an atomic radius greater than that of zinc.

In the method of an embodiment, the amount of the metal carbonate as added or the amount of the carbonate ion provided therefrom may be less than or equal to about 25%, less than or equal to about 20%, less than or equal to about 15%, less than or equal to about 10%, less than or equal to about 9%, less than or equal to about 8%, less than or equal to about 7%, less than or equal to about 6%, based on the Zn content (e.g., total Zn molar content) supplied to the reaction system. In the method of an embodiment, the amount of the metal carbonate as added or the amount of the carbonate ion provided therefrom may be greater than or equal to about 0.5%, greater than or equal to about 1 %, greater than or equal to about 3%, greater than or equal to about 6%, greater than or equal to about 9%, based on the Zn content supplied to the reaction system.

The layer including the zinc oxide nanoparticle may be used as an electron transport layer in an electroluminescent device including a quantum dot-containing light emitting layer. The present inventors have found that the zinc oxide nanoparticle manufactured by a method according to conventional methods can generate a significant amount of leakage current when applied to an electron transport layer. Without wishing to be bound by theory, it is believed that a current leakage can occur due to various trap levels present in the zinc oxide nanoparticle prepared with conventional methods. Without wishing to be bound by theory, it is believed that these various trap levels may result from defects on the surface and inside of the zinc oxide nanoparticle. In the prior art, a composition for forming a zinc oxide-containing electron transport layer may further include an additional additive or a dopant, and such a composition may not provide a desired level of dispersibility and may be difficult to use in an inkjet printing process wherein the composition needs to escape from an inkjet nozzle and be deposited in a pixel.

Surprisingly, the present inventors have found that the zinc oxide nanoparticles prepared by the method described herein (i.e., which involves the use of a metal carbonate compound together with a base as described) may exhibit a characteristic or a surface feature different from the zinc oxide nanoparticle synthesized with conventional art (e.g., as determined by the XPS analysis, the TGA, or a combination thereof). Without wishing to be bound by theory, it is believed that the zinc oxide nanoparticle according to an embodiment may have not only a surface passivation provided from the carboxylate moiety and the hydroxy moiety but also an additional passivation by carbonate ions on the surface of the particle. Without wishing to be bound by theory, it is believed that in the method according to an embodiment, the carbonate moiety provided to the synthesis reaction system can effectively passivate zinc dangling bonds that may be otherwise present on the particle surface.

It is believed that in an embodiment, the zinc oxide nanoparticle may have a surface ligand composition different from that of the conventional art, and accordingly, the leakage current of the device can be reduced through the trap passivation of the zinc oxide nanoparticle, and the balance of the hole and electron can be matched, thereby increasing the efficiency of the device and improving the life of the device. In an embodiment, an alkali metal or alkaline earth metal may have a larger atomic radius than zinc, and thus in the zinc oxide nanoparticle prepared in the presence of such metal carbonate compounds, the content of metal elements derived from metal carbonate compounds may be limited or controlled.

The base may contain a strong base. A pH of the base or of a solution of the base may be greater than or equal to about 8, greater than or equal to about 8.5, greater than or equal to about 9, greater than or equal to about 9.5, greater than or equal to about 10, greater than or equal to about 10.5, or greater than or equal to about 11.

The base may include a first base, a second base, or a combination thereof. The first base may include an organic base containing a C1 to C50 organic group (e.g., an aliphatic hydrocarbon group such as an alkyl group). The second base may include an inorganic base containing an alkali metal or an alkaline earth metal.

The first base may include a substituted or unsubstituted C1-C50 (e.g., C2-C40, C3-C30, C4-C25, C5-C20, C6-C15, C7-C14, C8-C12, C9-C11, or a combination thereof) aliphatic hydrocarbon group. The number of aliphatic hydrocarbon group may be 1, 2, 3, or 4. The first base may include a quaternary ammonium salt compound. The first base may include a tetraalkylammonium hydroxide (e.g., a tetra(C1-C6 alkyl) ammonium hydroxide, such as a tetramethylammonium hydroxide, tetraethylammonium hydroxide a diethyldimethylammonium hydroxide, a dimethyldipropylammonium hydroxide, or a combination thereof).

The second base may include an alkali metal hydroxide (e.g., a lithium hydroxide, a sodium hydroxide, a potassium hydroxide, a cesium hydroxide, a rubidium hydroxide, a francium hydroxide, or a combination thereof).

The second base may include at least one or at least two alkali metal hydroxides. The second base may include or may not include a lithium hydroxide. In an embodiment, the second base may include a sodium hydroxide, a potassium hydroxide, a cesium hydroxide, a rubidium hydroxide, or a combination thereof. The second base may include or may not include a lithium hydroxide, a sodium hydroxide, or a combination thereof. In an embodiment, the second base may include a potassium hydroxide, a cesium hydroxide, a rubidium hydroxide, or a combination thereof. In an embodiment, the second base may be used alone or may be used together with the first base.

In an embodiment, the base may include a second base, and the zinc oxide nanoparticle may further contain an alkali metal (e.g., lithium, potassium, rubidium, cesium, or a combination thereof).

In an embodiment, the first base may be used and a mole ratio between the first base and the second base (i.e., the first base:the second base) may be from about 1:0 to about 1:10, from about 1:0.1 to about 1:3, from about 1:0.3 to about 1:2.7, from about 1:0.5 to about 1:1.5, from about 1:0.7 to about 1:1.2, from about 1:0.8 to about 1:1.3, from about 1:0.9 to about 1:1.25, from about 1:1 to about 1:1.2, or a combination thereof.

In an embodiment, a mole ratio of the second base to the first base (the second base:the first base) may be from about 1:0 to about 1:10, from about 1:0.01 to about 1:10, from about 1:0.1 to about 1:3, from about 1:0.5 to about 1:27, from about 1:0.8 to about 1:1.5, from about 1:0.8 to about 1:1.2, from about 1:0.9 to about 1:1.3, from about 1:1 to about 1:1.25, or a combination thereof.

In an embodiment, a mole ratio of a sum of the zinc precursor and the first metal precursor with respect to a sum of the first base and the second base (the sum of metal precursors:the sum of the bases) may be from about 1:0.5 to about 1:5, from about 1:0.6 to about 1:4, from about 1:0.7 to about 1:3, from about 1:0.8 to about 1:2.5, from about 1:0.9 to about 1:2, from about 1:1 to about 1:1.5, from about 1:1.1 to about 1:1.48, from about 1:1.21 to about 1:1.45, from about 1:1.2 to about 1:1.35, or a combination thereof.

The mole ratio between the zinc precursor and the first metal precursor may be appropriately selected taking into consideration a desired composition of the zinc oxide nanoparticle. In an embodiment, the mole amount of the first metal precursor may be, per one mole of the zinc precursor, from about 0.1 mole to about 1.5 moles, from about 0.2 mole to about 1 mole, from about 0.3 mole to about 0.9 mole, from about 0.4 mole to about 0.8 mole, from about 0.5 mole to about 0.7 mole, or a combination thereof.

In the method of an embodiment, the first base and the second base may be dissolved in the solvent (for example, an alcohol solvent) and added. The first base and the second base may be added separately or may be added as a mixture.

In an embodiment, the base may include a C1 to C30 alkylammonium hydroxide compound, an alkali metal hydroxide, or a combination thereof, and the metal carbonate compound may include rubidium carbonate, rubidium bicarbonate, cesium bicarbonate, or a combination thereof.

The first temperature and time for the reaction can be appropriately adjusted. The first temperature for the reaction may be greater than or equal to about 0°C, for example, greater than or equal to about 10°C, greater than or equal to about 20°C, greater than or equal to about 25°C, greater than or equal to about 30°C, greater than or equal to about 35°C, greater than or equal to about 40°C, or greater than or equal to about 45°C. The temperature may be less than or equal to about 100 °C, less than or equal to about 80 °C, less than or equal to about 70 °C, less than or equal to about 65 °C, less than or equal to about 60 °C, less than or equal to about 55 °C, less than or equal to about 50 °C, or less than or equal to about 42 °C. The time for the reaction may be from about 10 minutes to 300 minutes. The reaction time may be greater than or equal to about 20 minutes, greater than or equal to about 40 minutes, greater than or equal to about 50 minutes, greater than or equal to about 70 minutes, greater than or equal to about 90 minutes, greater than or equal to about 110 minutes, greater than or equal to about 120 minutes, greater than or equal to about 130 minutes, or greater than or equal to about 140 minutes. The reaction time may be less than or equal to about 280 minutes, less than or equal to about 250 minutes, or less than or equal to about 150 minutes.

In the method of an embodiment, for example, to improve dispersibility of the nanoparticles as prepared, the addition of the base may be performed at a predetermined temperature for example, at room temperature, or at a temperature of about 20°C to about 40°C, or at a temperature of about 25 °C to about 30 °C. In the method of an embodiment, for example, to improve the dispersibility of the prepared particles, the reaction may be performed at a temperature of less than or equal to about 60 °C, for example, from about 20 to about 35 °C.

In an embodiment, the zinc oxide nanoparticles may have a core shell structure including a core and an outer layer (e.g., shell or an additional metal-containing layer) disposed on the core, and the core may include $Zn_{1-x}M_xO$ (herein, M includes magnesium, calcium, zirconium, tungsten, titanium, yttrium, aluminum, or a combination thereof, and x is greater than or equal to 0 and less than or equal to about 0.5). In $Zn_{1-x}M_xO$, x may be greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.2, greater than or equal to about 0.23, or greater than or equal to about 0.25. In $Zn_{1-x} M_xO$, x may be less than or equal to about 0.47, less than or equal to about 0.45, less than or equal to about 0.43, less than or equal to about 0.4, less than or equal to about 0.37, less than or equal to about 0.35, or less than or equal to about 0.3. In an embodiment, M may be magnesium; and calcium, zirconium, tungsten, titanium, yttrium, aluminum, or a combination thereof.

The outer layer may include a metal oxide including the first metal and optionally zinc. The metal oxide included in the outer layer may have a composition different from that of the core. The metal oxide included in the outer layer may include a gallium oxide. The outer layer of the zinc oxide nanoparticle may include an alkali metal (for example, provided from the base) and optionally an organic material. In an embodiment, the alkali metal may be bonded or adsorbed in the zinc oxide nanoparticle or on a surface of the zinc oxide nanoparticle (or on a hydroxy group on the particle surface).

In the method of an embodiment, the providing of the zinc oxide nanoparticle with a core-shell structure, for example, may further include dispersing the zinc oxide nanoparticle in a third solvent; and forming an additional metal-containing layer (e.g., an oxide layer of the additional metal) on the zinc oxide nanoparticles by adding a precursor for additional metal and a base to the third solvent to conduct a reaction. The additional metal may include an alkaline earth metal, zirconium, tungsten, titanium, yttrium, gallium, indium, tin, cobalt, vanadium, or a combination thereof. The third solvent may include a C1 to C10 alcohol solvent, dimethyl sulfoxide, a C3 to C30 (C15) hydrocarbon solvent (e.g., an aliphatic hydrocarbon solvent, an aromatic hydrocarbon solvent, an alicyclic hydrocarbon solvent, or a solvent having a benzene ring in which one or more double bonds are hydrogenated).

The zinc oxide nanoparticle prepared by the method of an embodiment or the electron transport layer including the same may exhibit a molar ratio or a property (an X-ray photoelectron spectroscopy property, an UV-Vis absorption spectroscopy property, a quenching property with a light emitting layer including quantum dots, a trap light emission, a dispersion property, etc.) as described herein. The features such as the presence of each component in the zinc oxide nanoparticles or the molar ratio therebetween can be determined or measured by an appropriate analysis means (X-ray photoelectron spectroscopy, inductively coupled plasma atomic emission spectroscopy, scanning or transmission electron microscope energy dispersive spectroscopy, etc.).

In the zinc oxide nanoparticle, a mole ratio of the first metal (e.g., magnesium) to zinc may be less than or equal to about 0.5:1, less than or equal to about 0.45:1, less than or equal to about 0.35:1, less than or equal to about 0.3:1, less than or equal to about 0.25:1, less than or equal to about 0.2:1. less than or equal to about 0.14:1, or less than or equal to about 0.13:1. In the zinc oxide nanoparticle, a mole ratio of the first metal (e.g., magnesium) to zinc may be greater than or equal to about 0.01:1, greater than or equal to about 0.03:1, greater than or equal to about 0.05:1, greater than or equal to about 0.07:1, greater than or equal to about 0.09:1, greater than or equal to about 0.1:1, greater than or equal to about 0.12:1, greater than or equal to about 0.14:1, greater than or equal to about 0.16:1, greater than or equal to about 0.18:1, or greater than or equal to about 0.24:1.

In the zinc oxide nanoparticle of an embodiment, the first metal may include two or more types of metals. In an embodiment, the zinc oxide nanoparticle may further include a Group 13 metal (e.g., gallium, aluminum, or a combination thereof) together with magnesium, and the amount of the Group 13 metal (e.g., gallium or aluminum) in the zinc oxide nanoparticle may be greater than or equal to about 1 mol% (i.e., greater than or equal to about 0.01:1 as a mole ratio), greater than or equal to about 5 mol%, 10 mol% or more, or 15 mol% or more to 30 mol% or less (i.e., less than or equal to about 0.3:1 as a mole ratio), 12 mol% or less, 8 mol% or less, or 6 mol% or less, based on a total moles of zinc, magnesium, and gallium.

In the zinc oxide nanoparticle of an embodiment, a mole ratio of a Group 13 metal to zinc (Group 13 metal:Zn) may be greater than or equal to about 0.04:1, greater than or equal to about 0.042:1, greater than or equal to about 0.044:1, greater than or equal to about 0.048:1, greater than or equal to about 0.05:1, greater than or equal to about 0.06:1, greater than or equal to about 0.07:1, greater than or equal to about 0.08:1, greater than or equal to about 0.085:1, greater than or equal to about 0.09:1, greater than or equal to about 0.1:1, greater than or equal to about 0.11:1, greater than or equal to about 0.115:1, greater than or equal to about 0.12:1, greater than or equal to about 0.13:1, greater than or equal to about 0.15:1, greater than or equal to about 0.17:1, greater than or equal to about 0.18:1, greater than or equal to about 0.19:1, greater than or equal to about 0.2:1, greater than or equal to about 0.21:1, or greater than or equal to about 0.25:1. In the zinc oxide nanoparticle of an embodiment, a mole ratio of a Group 13 metal to zinc (Group 13 metal:Zn) may be less than or equal to about 0.7:1, less than or equal to about 0.5:1, less than or equal to about 0.4:1, less than or equal to about 0.35:1, less than or equal to about 0.3:1, less than or equal to about 0.25:1, less than or equal to about 0.23:1, less than or equal to about 0.21:1, less than or equal to about 0.2:1, less than or equal to about 0.16:1, or less than or equal to about 0.15:1.

In the zinc oxide nanoparticle of an embodiment, a mole ratio of a Group 13 metal to magnesium (Group 13 metal:Mg) may be greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, greater than or equal to about 0.32:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.3:1, greater than or equal to about 1.5:1, greater than or equal to about 1.7:1, greater than or equal to about 1.9:1, greater than or equal to about 2:1, or greater than or equal to about 2.1:1. In the zinc oxide nanoparticle of an embodiment, a mole ratio of a Group 13 metal to magnesium (Group 13 metal:Mg) may be less than or equal to about 3.2:1, less than or equal to about 3.1:1, less than or equal to about 3:1, less than or equal to about 2.9:1, less than or equal to about 2.8:1, less than or equal to about 2.7:1, less than or equal to about 2.6:1, less than or equal to about 2.5:1, less than or equal to about 2.4:1, less than or equal to about 2.35:1, less than or equal to about 2.3:1, less than or equal to about 2.2:1, less than or equal to about 2.1:1, less than or equal to about 2:1, less than or equal to about 1.8:1, less than or equal to about 1.6:1, less than or equal to about 1.4:1, less than or equal to about 1.2:1, less than or equal to about 1.1:1, less than or equal to about 1:1, less than or equal to about 0.9:1, or less than or equal to about 0.85:1.

In the zinc oxide nanoparticle of an embodiment, a molar ratio of a sum of magnesium and Group 13 metal to zinc [(Mg+Group 13 metal):Zn] may be greater than or equal to about 0.15:1, greater than or equal to about 0.155:1, greater than or equal to about 0.16:1, greater than or equal to about 0.165:1, greater than or equal to about 0.17:1, greater than or equal to about 0.175:1, greater than or equal to about 0.18:1, greater than or equal to about 0.19:1, greater than or equal to about 0.2:1, greater than or equal to about 0.21:1, greater than or equal to about 0.22:1, greater than or equal to about 0.23:1, greater than or equal to about 0.24:1, greater than or equal to about 0.25:1, greater than or equal to about 0.26:1, greater than or equal to about 0.27:1, greater than or equal to about 0.28:1, greater than or equal to about 0.29:1, greater than or equal to about 0.3:1, or greater than or equal to about 0.35:1. In the zinc oxide nanoparticle of an embodiment, a molar ratio of a sum of magnesium and Group 13 metal to zinc [(Mg+Group 13 metal):Zn] may be less than or equal to about 0.7:1, less than or equal to about 0.6:1, less than or equal to about 0.5:1, less than or equal to about 0.45:1, less than or equal to about 0.4:1, less than or equal to about 0.35:1, less than or equal to about 0.33:1, less than or equal to about 0.31:1, less than or equal to about 0.29:1, less than or equal to about 0.26:1, less than or equal to about 0.23:1, or less than or equal to about 0.2:1.

The zinc oxide nanoparticles according to an embodiment may or may not include an alkali metal (e.g., which may be provided from an alkali metal-containing base) together with the first metal.

A mole ratio of an alkali metal (e.g., sodium, potassium, cesium, rubidium, or their total number of moles) to the first metal (e.g., magnesium or a total number of moles when two or more first metals are present) may be greater than or equal to about 0.005:1, greater than or equal to about 0.01:1, greater than or equal to about 0.015:1, greater than or equal to about 0.02:1, greater than or equal to about 0.025:1, greater than or equal to about 0.03:1, greater than or equal to about 0.04:1, greater than or equal to about 0.05:1, greater than or equal to about 0.06:1, greater than or equal to about 0.07:1, greater than or equal to about 0.08:1, greater than or equal to about 0.09:1, greater than or equal to about 0.1:1, greater than or equal to about 0.11:1, greater than or equal to about 0.12:1, greater than or equal to about 0.13:1, greater than or equal to about 0.14:1, greater than or equal to about 0.15:1, greater than or equal to about 0.16:1, greater than or equal to about 0.17:1, greater than or equal to about 0.18:1, greater than or equal to about 0.19:1, greater than or equal to about 0.2:1, greater than or equal to about 0.22:1, greater than or equal to about 0.24:1, greater than or equal to about 0.26:1, greater than or equal to about 0.28:1, greater than or equal to about 0.3:1, greater than or equal to about 0.32:1, greater than or equal to about 0.34:1, greater than or equal to about 0.36:1, greater than or equal to about 0.38:1, greater than or equal to about 0.4:1, greater than or equal to about 0.42:1, greater than or equal to about 0.44:1, greater than or equal to about 0.46:1, greater than or equal to about 0.48:1, or greater than or equal to about 0.5:1. In the zinc oxide nanoparticle of an embodiment, a mole ratio of the alkali metal to the first metal may be less than or equal to about 2:1, less than or equal to about 1.7:1, less than or equal to about 1.5:1, less than or equal to about 1.3:1, less than or equal to about 1.1:1, less than or equal to about 1:1, less than or equal to about 0.9:1, less than or equal to about 0.7:1, less than or equal to about 0.65:1, or less than or equal to about 0.6:1.

In the zinc oxide nanoparticle of an embodiment, a molar ratio of an alkali metal (e.g., sodium, potassium, cesium, rubidium, or their total) to zinc may be greater than or equal to about 0.01:1, greater than or equal to about 0.02:1, greater than or equal to about 0.03:1, greater than or equal to about 0.035:1, greater than or equal to about 0.04:1, greater than or equal to about 0.05:1, greater than or equal to about 0.07:1, greater than or equal to about 0.09:1, greater than or equal to about 0.1:1, greater than or equal to about 0.13:1, or greater than or equal to about 0.15:1. In the zinc oxide nanoparticle of an embodiment, a molar ratio of an alkali metal (e.g., sodium, potassium, cesium, rubidium, or their total) to zinc may be less than or equal to about 0.5:1, less than or equal to about 0.4:1, less than or equal to about 0.3:1, less than or equal to about 0.2:1, less than or equal to about 0.1:1, less than or equal to about 0.08:1, less than or equal to about 0.06:1, or less than or equal to about 0.045:1.

In the zinc oxide nanoparticle of an embodiment, a molar ratio of a sum of the first metal and an alkali metal to zinc may be [(first metal+alkali metal):zinc)] may be greater than or equal to about 0.1:1, greater than or equal to about 0.15:1, greater than or equal to about 0.17:1, greater than or equal to about 0.19:1, greater than or equal to about 0.2:1, greater than or equal to about 0.21:1, greater than or equal to about 0.23:1, greater than or equal to about 0.25:1, greater than or equal to about 0.27:1, greater than or equal to about 0.29:1, or greater than or equal to about 0.3 and less than or equal to about 1:1, less than or equal to about 0.9:1, less than or equal to about 0.8:1, less than or equal to about 0.7:1, less than or equal to about 0.6:1, less than or equal to about 0.5:1, less than or equal to about 0.4:1, less than or equal to about 0.35:1, less than or equal to about 0.34:1, or less than or equal to about 0.31:1.

In an XPS analysis of the zinc oxide nanoparticle of an embodiment, a zinc spectrum (e.g., a Zn2p spectrum) may exhibit a peak (e.g., a maximum intensity) at a binding energy of less than or equal to about 1047 eV (e.g., less than or equal to about 1045 eV) and greater than or equal to about 1042 eV.

In the XPS analysis of the zinc oxide nanoparticle of an embodiment, the oxygen (e.g., O1s) spectrum may have a full width at half maximum (FWHM) of less than 4 eV, less than or equal to about 3.9 eV, less than or equal to about 3.8 eV, less than or equal to about 3.7 eV, less than or equal to about 3.6 eV, less than or equal to about 3.5 eV, less than or equal to about 3.4 eV, less than or equal to about 3.3 eV, less than or equal to about 3.2 eV, less than or equal to about 3.1 eV, less than or equal to about 3 eV, less than or equal to about 2.9 eV, less than or equal to about 2.8 eV, less than or equal to about 2.7 eV, less than or equal to about 2.6 eV, less than or equal to about 2.5 eV, less than or equal to about 2.4 eV, less than or equal to about 2.3 eV, less than or equal to about 2.25 eV, less than or equal to about 2.2 eV, less than or equal to about 2.1 eV, or less than or equal to about 2 eV. In the XPS analysis of the zinc oxide nanoparticle of an embodiment, the oxygen (e.g., O1s) spectrum may have a FWHM of greater than or equal to about 1 eV, greater than or equal to about 1.2 eV, greater than or equal to about 1.5 eV, greater than or equal to about 1.8 eV, greater than or equal to about 1.9 eV, greater than or equal to about 2. eV, greater than or equal to about 2.3 eV, greater than or equal to about 2.5 eV, or greater than or equal to about 2.7 eV.

In an embodiment, the oxygen (e.g., O1s) intensity spectrum of the XPS analysis may have a half width at half maximum (HWHM) of less than or equal to about 3.5 eV, less than or equal to about 3.3 eV, less than or equal to about 3.1 eV, less than or equal to about 3 eV, less than or equal to about 2.9 eV, less than or equal to about 2.7 eV, less than or equal to about 2.5 eV, less than or equal to about 2.3 eV, less than or equal to about 2.2 eV, less than or equal to about 2.1 eV, less than or equal to about 2 eV, less than or equal to about 1.9 eV, less than or equal to about 1.8 eV, less than or equal to about 1.7 eV, less than or equal to about 1.6 eV, less than or equal to about 1.5 eV, less than or equal to about 1.4 eV, less than or equal to about 1.3 eV, less than or equal to about 1.2 eV, less than or equal to about 1.1 eV, less than or equal to about 1 eV, or less than or equal to about 0.98 eV. the oxygen (e.g., O1s) intensity spectrum of the XPS analysis may have a half width at half maximum (HWHM) of greater than or equal to about 0.5 eV, greater than or equal to about 0.7 eV, or greater than or equal to about 0.8 eV.

In the XPS analysis of zinc oxide nanoparticle of an embodiment, the O1s XPS intensity spectrum may include (e.g., may be resolved) a peak representing a metal-oxygen bond (hereinafter referred to as a first oxygen peak), a peak representing a hydroxyl moiety (hereinafter referred to as a third oxygen peak), or other peaks (e.g., a peak representing passivation by a ligand, for example, a second oxygen peak), and the total sum of the peaks may be understood to be the O1s XPS intensity spectrum. The second oxygen peak may appear at higher binding energy than the first oxygen peak, and the third oxygen peak may appear at higher binding energy than the second oxygen peak. The first oxygen peak, the second oxygen peak, and the third oxygen peak may be each independently, for example, greater than or equal to about 525 eV, greater than or equal to about 527 eV, greater than or equal to about 528 eV, greater than or equal to about 530 eV, or greater than or equal to about 531 eV and less than or equal to about 535 eV, less than or equal to about 533 eV, less than or equal to about 531 eV, less than or equal to about 530 eV, less than or equal to about 529 eV, less than or equal to about 528 eV, less than or equal to about 526 eV, or a combination thereof.

The present inventors have found that the zinc oxide nanoparticle of an embodiment may exhibit an O1s XPS intensity spectrum as described herein, which may represent a surface aspect of the zinc oxide nanoparticle described herein. The zinc oxide nanoparticle of an embodiment may exhibit improved passivation, and thus the ratio of the maximum intensity of the first oxygen peak to the maximum intensity of the second oxygen peak may be significantly reduced.

In the O1s XPS intensity spectrum of the zinc oxide nanoparticle of an embodiment, an intensity ratio of the first oxygen peak to the second oxygen peak (first oxygen peak: second oxygen peak) may be less than or equal to about 0.8:1, less than or equal to about 0.7:1, less than or equal to about 0.65:1, less than or equal to about 0.6:1, less than or equal to about 0.55:1, less than or equal to about 0.5:1, or less than or equal to about 0.45:1. The intensity ratio of the first oxygen peak to the second oxygen peak may be greater than or equal to about 0.05:1, greater than or equal to about 0.1:1, greater than or equal to about 0.3:1, greater than or equal to about 0.35:1, greater than or equal to about 0.4:1, greater than or equal to about 0.45:1, greater than or equal to about 0.5:1, or greater than or equal to about 0.55:1. In the O1s XPS spectrum of zinc oxide nanoparticles of one embodiment, the ratio of an intensity at 530 eV binding energy to an maximum intensity may be less than or equal to about 0.4:1, less than or equal to about 0.35:1, less than or equal to about 0.32:1, less than or equal to about 0.3:1, or less than or equal to about 0.25:1.

The zinc oxide nanoparticles may further include an alkali metal. In this case, in the zinc oxide nanoparticles, a peak related to alkali metals (e.g., Rb3p peak) may be expressed, for example, in a predetermined range (for Rb, in the range of greater than or equal to about 230 eV to less than or equal to about 250 eV, greater than or equal to about 235 eV to less than or equal to about 245 eV, less than or equal to about 237 eV to less than or equal to about 240 eV, less than or equal to about 245 eV to less than or equal to about 250 eV, or a combination thereof). The peak for the alkali metal may be at least two peaks.

The zinc oxide nanoparticles prepared according to the method of an embodiment may exhibit different decomposition patterns in a thermogravimetric analysis.

As determined by a differential thermogravimetric analysis (DTGA), the zinc oxide nanoparticle of an embodiment or the electron transport layer including the zinc oxide nanoparticle of an embodiment may show a temperature representing maximum weight reduction (a maximum weight reduction temperature) of greater than or equal to about 200 °C, greater than or equal to about 250 °C, greater than or equal to about 290 °C, or greater than or equal to about 300 °C. The maximum weight reduction temperature of the zinc oxide nanoparticle or the electron transport layer may be less than or equal to about 400 °C, or less than or equal to about 380 °C. In an embodiment, the zinc oxide nanoparticles or the electron transport layer may exhibit a maximum peak temperature in the DTGA curve obtained by differentiating the TGA curve, for example, in a relatively high temperature range of greater than or equal to 200°C, greater than or equal to about 250°C, greater than or equal to about 280°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 325°C, greater than or equal to about or 330°C or higher to 350°C, less than or equal to about 345°C, less than or equal to about 340°C, less than or equal to about 335°C, less than or equal to about 330°C, or less than or equal to about 327°C.

As determined at a decomposition temperature of 500°C or more (e.g., 600°C) in a thermogravimetric analysis, the zinc oxide nanoparticles or the electron transport layer prepared according to the method of an embodiment may exhibit a total weight loss of greater than or equal to about 22 weight percent (wt%), greater than or equal to about 23 wt%, greater than or equal to about 24 wt%, greater than or equal to about 25 wt%, greater than or equal to about 26 wt%, greater than or equal to about 27 wt%, greater than or equal to about 29 wt%, greater than or equal to about 30 wt%, greater than or equal to about 31 wt%, or greater than or equal to about 32 wt%. In an embodiment, the total weight loss may be less than or equal to about 50 wt%, less than or equal to about 45 wt%, less than or equal to about 40 wt%, less than or equal to about 39 wt%, less than or equal to about 37 wt%, less than or equal to about 36 wt%, or less than or equal to about 35 wt%. In an embodiment, the zinc oxide nanoparticle or the electron transport layer as prepared may exhibit a weight residue of greater than or equal to about 50 wt%, greater than or equal to about 55 wt%, greater than or equal to about 60 wt%, or greater than or equal to about or 65 wt% as determined at a decomposition temperature of greater than or equal to about 500°C (e.g., 550°C or 600°C) in the thermogravimetric analysis.

Without wishing to be bound by theory, in an embodiment, the zinc oxide nanoparticle may include a carboxylate moiety (e.g., an acetate moiety) and a hydroxyl moiety as well as a carbonate moiety on the surface, and these moieties are thought to be able to passivate a zinc oxide nanoparticle (for example, to passivate zinc dangling bonds placed on a surface of the particle) more, whereby the resulting particle may exhibit a relatively increased amount of the organic substance.

In an electroluminescent device of an embodiment, as being analyzed by UV-Vis absorption spectroscopy, the zinc oxide nanoparticle exhibit a first absorption peak wavelength of greater than or equal to about 285 nm, greater than or equal to about 289 nm, greater than or equal to about 292 nm, or greater than or equal to about 295 nm and less than or equal to about 330 nm, less than or equal to about 315 nm, less than or equal to about 302 nm, less than or equal to about 300 nm, less than or equal to about 299 nm, less than or equal to about 298 nm, or less than or equal to about 297 nm. When the zinc oxide nanoparticle is analyzed by UV-Vis absorption spectroscopy, the zinc oxide nanoparticles exhibit a first absorption peak wavelength of less than or equal to about 320 nm, less than or equal to about 319 nm, less than or equal to about 318 nm, less than or equal to about 317 nm, less than or equal to about 316 nm, less than or equal to about 315 nm, less than or equal to about 314 nm, less than or equal to about 313 nm, less than or equal to about 312 nm, or less than or equal to about 311 nm. The first absorption peak wavelength may be greater than or equal to about 290 nm. The first absorption peak wavelength may be greater than or equal to about 295 nm, greater than or equal to about 300 nm, greater than or equal to about 301 nm, greater than or equal to about 302 nm, or greater than or equal to about 303 nm.

When the zinc oxide nanoparticle is analyzed by an UV-Vis absorption spectroscopy, the UV-Vis absorption spectrum has a valley that is adjacent to the first absorption peak, and a valley depth of the valley, defined by Equation 1, may be greater than or equal to about 0.01, greater than or equal to about 0.02, greater than or equal to about 0.027, greater than or equal to about 0.03, greater than or equal to about 0.035, greater than or equal to about 0.04, greater than or equal to about 0.045, greater than or equal to about 0.05, greater than or equal to about 0.055, or greater than or equal to about 0.06:

$$1 - (Abs_{valley} / Abs_{first}) = VD \qquad (1)$$

wherein $Abs_{first}$ is an absorbance at a wavelength of the first absorption peak and $Abs_{valley}$ is an absorbance at a lowest point of the valley, and VD is the valley depth.

The valley depth (VD) may be less than or equal to about 0.2, less than or equal to about 0.15, less than or equal to about 0.12, less than or equal to about 0.1, less than or equal to about 0.08, less than or equal to about 0.07, or less than or equal to about 0.06.

In an embodiment, the zinc oxide nanoparticle may have a bandgap energy of greater than or equal to about 3.6 eV, greater than or equal to about 3.65 eV, greater than or equal to about 3.7 eV, greater than or equal to about 3.75 eV, greater than or equal to about 3.77 eV, greater than or equal to about 3.78 eV, or greater than or equal to about 3.79 eV, and less than or equal to about 3.95 eV, less than or equal to about 3.94 eV, less than or equal to about 3.9 eV, less than or equal to about 3.85 eV, less than or equal to about 3.8 eV, less than or equal to about 3.78 eV, less than or equal to about 3.77 eV, less than or equal to about 3.75 eV, or less than or equal to about 3.7 eV. The bandgap energy may be determined by UV-Vis absorption spectroscopy analysis, for example, by X-intercept value of a tangent line of a UV-Vis absorption curve.

In the photoluminescence spectrum obtained by irradiating light with a wavelength of 300 nm, the zinc oxide nanoparticle may exhibit a defect emission peak that has an intensity ratio of less than or equal to about 10:1, less than or equal to about 9:1, less than or equal to about 8:1, less than or equal to about 7:1, less than or equal to about 6:1, less than or equal to about 5:1, less than or equal to about 4:1, less than or equal to about 3:1, less than or equal to about 2:1, or less than or equal to about 1:1 with respect to a band edge emission peak. In the photoluminescence spectrum obtained by irradiating light with a wavelength of 300 nm, the zinc oxide nanoparticle may exhibit a defect emission peak that has an intensity ratio of greater than or equal to about 0.1:1, greater than or equal to about 0.5:1, greater than or equal to about 0.9:1, or greater than or equal to about 1:1 with respect to a band edge emission peak. The band edge emission peak wavelength may be greater than or equal to about 350 nm and less than or equal to about 400 nm. The defect emission peak wavelength may be greater than or equal to about 450 nm and less than or equal to about 550 nm.

When zinc oxide nanoparticles prepared by the conventional art are disposed on the quantum dot emission layer, the photoluminescent properties (e.g., photoluminescent quantum yield) of the quantum dot emission layer may be significantly reduced (hereinafter, referred to as a PL quenching phenomenon). Without wishing to be bound by any theory, it is believed that the PL quenching phenomenon may be due to the Forster Resonance Energy Transfer (FRET) of the quantum dots and the traps present in the emission layer or the electron transport layer. The present inventors have found that, surprisingly, the layer including the zinc oxide nanoparticle according to an embodiment may not cause such a PL quenching phenomenon when disposed on the quantum dot emission layer. In an embodiment, the laminated structure including a semiconductor nanocrystal particle-containing emission layer and an electron transport layer based on the zinc oxide nanoparticles disposed on the emission layer may exhibit the same or greater luminous efficiency of the emission layer.

In an embodiment, the zinc oxide nanoparticle may have a dispersibility desired for example in a solution process of the production method of the electroluminescent device. In an embodiment, the zinc oxide nanoparticle may exhibit, as dispersed in an alcohol solvent and measured by dynamic light scattering analysis, an average particle diameter (may be referred to as a DLS average particle diameter, as well) of greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, or greater than or equal to about 7.5 nm. The DLS average particle diameter of the zinc oxide nanoparticle may be less than or equal to about 500 nm, less than or equal to about 300 nm, less than or equal to about 150 nm, less than or equal to about 100 nm, less than or equal to about 50 nm, less than or equal to about 40 nm, less than or equal to about 30 nm, less than or equal to about 20 nm, less than or equal to about 10 nm, less than or equal to about 9 nm, less than or equal to about 8.5 nm, less than or equal to about 8 nm, less than or equal to about 7.5 nm, or less than or equal to about 7 nm. In an aspect, the zinc oxide nanoparticle may have an average particle diameter of greater than or equal to about 5 nm and less than or equal to about 20 nm, when dispersed in the alcohol solvent and the average particle diameter is measured by dynamic light scattering analysis.

In an embodiment, the zinc oxide nanoparticle may have a size or an average size (hereinafter, simply referred to as "size") of greater than or equal to about 1 nm, greater than or equal to about 3 nm, greater than or equal to about 5 nm, or greater than or equal to about 7 nm. The zinc oxide nanoparticle may have a size of less than or equal to about 50 nm, for example, less than or equal to about 10 nm, less than or equal to about 8 nm, less than or equal to about 7.2 nm, or less than or equal to about 6.2 nm. The size of the zinc oxide nanoparticle may be a diameter or equivalent diameter converted by assuming a spherical shape when not spherical. The size of the zinc oxide nanoparticle may be measured with an electron microscope [e.g., transmission electron microscopy (TEM)] analysis (e.g., a two dimensional TEM image).

In an embodiment, the electron auxiliary layer (e.g., the electron transport layer) including the zinc oxide nanoparticle may be prepared in a solution process. In an embodiment, the electron transport layer may be formed by dispersing the zinc oxide nanoparticle in an organic solvent (e.g., a polar organic solvent, a non-polar organic solvent, or a combination thereof) to obtain a dispersion for forming an electron transport layer and applying the dispersion to form a film. In an embodiment, the dispersion for forming an electron transport layer may be applied on the light emitting layer. The solution process may further include removing the organic solvent from the formed film (e.g., through evaporation or a thermal treatment). A thermal treatment (i.e., heat treatment) may be conducted at a temperature of greater than or equal to about 50°C, greater than or equal to about 60°C, greater than or equal to about 70°C, or greater than or equal to about 85°C and less than or equal to about 100°C.

In an embodiment, a thickness of the electron transport layer may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, an electron injection layer may be further disposed between the electron transport layer and the second electrode. The material of the electron injection layer is not particularly limited and can be selected appropriately.

In an embodiment, the electroluminescent device may further include a hole auxiliary layer 2, or 20, between the first electrode 1, or 10, and the light emitting layer 3, or 30. The hole auxiliary layer 2, or 20, may include a hole injection layer, a hole transport layer, an electron blocking layer, or a combination thereof. The hole auxiliary layer 2, or 20, may be a single layer or a multilayer structure in which adjacent layers include different components as shown in FIGS. 1 to 3.

The hole auxiliary layer 2, or 20, may have a HOMO energy level that can be matched with the HOMO energy level of the light emitting layer 3, or 30, in order to enhance mobility of holes transferred from the hole auxiliary layer 2, or 20, to the light emitting layer 3, or 30. In an embodiment, the hole auxiliary layer 2, or 20, may include a hole injection layer close to, e.g., adjacent, the first electrode 1, or 10, and a hole transport layer close to, e.g., adjacent, the light emitting layer 3, or 30.

In an embodiment, the material included in the hole auxiliary layer 2, or 20 (e.g., a hole transport layer, a hole injection layer, or an electron blocking layer), is not particularly limited, and may include, for example, poly(9,9-dioctyl-fluorene-co-N-(4)-butylphenyl)-diphenylamine) (TFB), polyarylamine, poly(N-vinylcarbazole), poly(3,4-ethylenedioxythiophene) (PEDOT), poly(3,4-ethylenedioxythiophene):polystyrene sulfonate (PEDOT: PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA (4,4',4"-Tris[phenyl(m-tolyl)amino]triphenylamine), 4,4',4"-tris(N-carbazolyl)-triphenylamine (TCTA), 1,1-bis[(di-4-toylamino)phenyl]cyclohexane (TAPC), a p-type metal oxide (e.g., NiO, $WO_3$, $MoO_3$, etc.), a carbon- containing material such as graphene oxide, or a combination thereof, but is not limited thereto.

In the hole auxiliary layer, a thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 35 nm, or less than or equal to about 30 nm, but is not limited thereto.

A device according to an embodiment may have a structure for example, as shown in FIG. 3A. In an embodiment, and referring to FIG. 2, in the device, the anode 10 disposed on the transparent substrate 100 may include a metal oxide-containing transparent electrode (e.g., an ITO electrode), and the cathode 50 facing the anode 10 may include a conductive metal. The conductive metal may have a relatively low work function, such as Mg, Al, etc.. The hole auxiliary layer 20 may be provided between the transparent electrode 100 and the light emitting layer 30. The hole auxiliary layer 20 may be a hole injection layer such as PEDOT:PSS, or p-type metal oxide, or a hole transport layer such as TFB, or polyvinylcarbazole (PVK). The hole injection layer may be disposed close to the transparent electrode and the hole transport layer may be disposed close to the light emitting layer. The electron auxiliary layer 40 including an electron transport layer and optionally an electron injection layer may be disposed between the light emitting layer 30 and the cathode 50. The details of the electron transport layer may be as described above.

A device according to another embodiment may have an inverted structure. Herein, the second electrode 50 disposed on the transparent substrate 100 may include a metal oxide-containing transparent electrode, and the anode 10 facing the cathode 50 may include a metal. For example, the metal oxide of the metal oxide-containing transparent electrode may be ITO and the anode may be a metal with a relatively high work function, such as Au, Ag, etc.. For example, an electron auxiliary layer 40 (including an electron transport layer and optionally an electron injection layer) may be disposed between the transparent electrode 50 and the light emitting layer 30. The details of the electron transport layer may be as described above. MoOs or other p-type metal oxide may be disposed as a hole auxiliary layer 20 between the metal anode 10 and the light emitting layer 30 as shown in FIG. 3B. For example, the hole auxiliary layer 20 may be a hole transport layer including TFB, or PVK, or a hole injection layer including MoOs, or other p-type metal oxide.

The above device may be produced by an appropriate method. For example, the electroluminescent device may be produced by optionally forming a hole auxiliary layer on a substrate on which a first electrode is formed, forming a light emitting layer including semiconductor nanoparticles , forming an electron auxiliary layer (including an electron transport layer) on the light emitting layer, and forming a second electrode on the electron auxiliary layer. A method of forming the electrode/hole auxiliary layer/light emitting layer may be appropriately selected and is not particularly limited. Forming of the hole auxiliary layer may be performed by deposition or coating. Forming a light emitting layer including semiconductor nanoparticles may include forming a pattern of the semiconductor nanoparticles. Forming an electron auxiliary layer may be performed by vapor deposition or coating.

An electroluminescent device of an embodiment may exhibit an improved level of electroluminescent properties along with an extended life-span as described above.

In an embodiment, the electroluminescent device may have a maximum external quantum efficiency (EQE) of greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The maximum external quantum efficiency (EQE) may be less than or equal to about 40%, less than or equal to about 30%, or less than or equal to about 20%.

The electroluminescent device of an embodiment may have a maximum luminance of greater than or equal to about 50,000 candelas per square meter ($cd/m^2$), greater than or equal to about 60,000 $cd/m^2$, greater than or equal to about 70,000 $cd/m^2$, greater than or equal to about 80,000 $cd/m^2$, greater than or equal to about 90,000 $cd/m^2$, greater than or equal to about 100,000 $cd/m^2$, greater than or equal to about 150,000 $cd/m^2$, greater than or equal to about 200,000 $cd/m^2$, greater than or equal to about 250,000 $cd/m^2$, greater than or equal to about 300,000 $cd/m^2$, greater than or equal to about 310,000 $cd/m^2$, greater than or equal to about 320,000 $cd/m^2$, greater than or equal to about 330,000 $cd/m^2$, greater than or equal to about 340,000 $cd/m^2$, greater than or equal to about 350,000 $cd/m^2$, greater than or equal to about 360,000 $cd/m^2$, greater than or equal to about 370,000 $cd/m^2$, greater than or equal to about 380,000 $cd/m^2$, greater than or equal to about 390,000 $cd/m^2$, greater than or equal to about 400,000 $cd/m^2$, greater than or equal to about 440,000 $cd/m^2$, greater than or equal to about 500,000 $cd/m^2$, or greater than or equal to about 550,000 $cd/m^2$. The maximum luminance may be from about 50,000 $cd/m^2$ to about 1,000,000 $cd/m^2$, from about 70,000 $cd/m^2$ to about 600,000 $cd/m^2$, or from about 90,000 $cd/m^2$ to about 500,000 $cd/m^2$.

The electroluminescent device of an embodiment may be configured to emit blue light, green light, or red light. The peak emission wavelength of the blue light, the peak emission wavelength of the green light, or the peak emission wavelength of the red light are the same as described herein.

In an embodiment, as measured by driving the electroluminescent device at a predetermined initial luminance (for example, about 650 nit), the electroluminescent device may exhibit a T50 of greater than or equal to about 200 hours, greater than or equal to about 250 hours, greater than or equal to about 300 hours, greater than or equal to about 350 hours, greater than or equal to about 400 hours, greater than or equal to about 450 hours, greater than or equal to about 500 hours, greater than or equal to about 550 hours, greater than or equal to about 600 hours, greater than or equal to about 650 hours, or greater than or equal to about 700 hours. The T50 may be from about 275 hours to about 4000 hours, from about 330 hours to about 2000 hours, from about 350 hours to about 1500 hours, from about 420 hours to about 1000 hours, or from about 430 hours to about 900 hours.

In an embodiment, as measured by driving the device at a predetermined initial luminance (for example, about 650 nit), the electroluminescent device may have a T90 of greater than or equal to about 5 hours, e.g., a T90 of greater than or equal to about 10 hours, greater than or equal to about 20 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, greater than or equal to about 110 hours, greater than or equal to about 120 hours, greater than or equal to about 130 hours, greater than or equal to about 140 hours, greater than or equal to about 150 hours, greater than or equal to about 160 hours, greater than or equal to about 170 hours, greater than or equal to about 180 hours, greater than or equal to about 190 hours, or greater than or equal to about 200 hours. The T90 may be from about 35 hours to about 1500 hours, from about 55 hours to about 1200 hours, from about 85 hours to about 1000 hours, from about 105 hours to about 900 hours, from about 115 hours to about 800 hours, or from about 145 hours to about 500 hours.

The electroluminescent device may have an initial voltage of less than or equal to about 3 volts, for example, less than or equal to about 2.9 volts, or less than or equal to about 2.88 volts (when driven at a predetermined luminance, for example, 650 nit). The initial voltage may be greater than or equal to about 2.5 volts, greater than or equal to about 2.6 volts, or greater than or equal to about 2.7 volts.

The electroluminescent device may have a leakage current density of 0.1 milliampere per square centimeter ($mA/cm^2$) or less, 0.05 $mA/cm^2$ or less, 0.01 $mA/cm^2$ or less, or 0.005 $mA/cm^2$ or less under an applied voltage condition of 1 volt. The leakage current density may be 0.0001 $mA/cm^2$ or more, 0.0005 $mA/cm^2$ or more, or 0.001 $mA/cm^2$ or more.

In an embodiment, a display device or an electronic apparatus may include the electroluminescent device.

The display device may include a first pixel and a second pixel configured to emit light of a color differing from that of the first pixel. In the first pixel, the second pixel, or both, the electroluminescent device according to an embodiment may be disposed. In an embodiment, the display device may include a blue pixel, a red pixel, a green pixel, or a combination thereof. In the display device, the red pixel may include a red light emitting layer including a plurality of red light emitting semiconductor nanoparticles, the green pixel may include a green light emitting layer including a plurality of green light emitting semiconductor nanoparticles, and the blue pixel may include a blue light emitting layer including a plurality of blue light emitting semiconductor nanoparticles. The electroluminescent device according to an embodiment may be disposed in the blue pixel, the red pixel, or the green pixel, for example, in the blue pixel.

Referring to FIG. 3C, a display panel 1000 according to an embodiment includes a display area 1000D for displaying an image and a non-display area 1000P disposed around the display area 1000D, in which the binding element may be located.

The display area 1000D may include a plurality of pixels PXs arranged along a row (e.g., X direction) and/or a column (e.g., Y direction), and each pixel PX may include a plurality of sub-pixels $PX_1$, $PX_2$, and $PX_3$ displaying different colors. As an example, a configuration in which three sub-pixels $PX_1$, $PX_2$, and $PX_3$ constitute one pixel PX is illustrated in FIG. 3C, but the configuration is not limited thereto. An additional sub-pixel such as a white sub-pixel may be further included, and one or more sub-pixel displaying the same color may be included. The plurality of pixels PXs may be arranged in, for example, a Bayer matrix, a PenTile matrix, and/or a diamond matrix, but is not limited thereto.

Each of the sub-pixels $PX_1$, $PX_2$, and $PX_3$ may be configured to display a color of three primary colors or a combination of three primary colors, for example, red, green, blue, or a combination thereof (e.g., white light). For example, the first sub-pixel $PX_1$ may be configured to display red, the second sub-pixel $PX_2$ may be configured to display green, and the third sub-pixel $PX_3$ may be configured to display blue.

In FIG 3C, each of the sub-pixels are depicted to have the same size, but the present disclosure is not limited thereto. For example, at least one of the sub-pixels may be larger or smaller, or have a different shape, than another sub-pixel.

In an embodiment, the display panel of an embodiment may include a light emitting panel 100 which may include a lower substrate 110, a buffer layer 111, a thin film transistor TFT, and a light emitting element 180. The display panel may further include a circuit element for switching and/or driving each of the light emitting elements.

Referring to FIG. 3D, in the light emitting panel of an embodiment, the light emitting element 180 may be disposed for each sub-pixel $PX_1$, $PX_2$, and $PX_3$. The light emitting element 180 disposed in each sub-pixel $PX_1$, $PX_2$, and $PX_3$ may be independently driven. The subpixel may include a blue subpixel, red subpixel, or a green subpixel. At least one of the light emitting element 180 may be an electroluminescent element according to an embodiment described herein.

Details of the substrate are the same as described herein. The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer or two or more layers and may cover a portion of or the entire surface of the lower substrate 110. The buffer layer 111 may be omitted.

The thin film transistor TFT may be a three terminal element for switching and/or driving the light emitting element 180, and one or two or more may be included for each sub-pixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. A coplanar top gate structure is shown as an example, but the structure is not limited thereto and may have various structures.

The gate electrode 124 is electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor such as amorphous silicon, polycrystalline silicon, or oxide semiconductor; an organic semiconductor; an organic-inorganic semiconductor; or a combination thereof.

For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. The semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an example in which the gate insulating layer 140 is formed on the entire surface of the lower substrate 110 is illustrated, but the present disclosure is not limited thereto and may be selectively formed between the gate electrode 124 and the semiconductor 154. The gate insulating layer 140 may be formed of one or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 is electrically connected to a data line (not shown), and the drain electrode 175 is electrically connected to a light emitting element 180.

An interlayer insulating layer 145 is additionally formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one or two or more layers.

A protective layer 160 is formed on the thin film transistor TFT The protective layer 160 may be, for example, a passivation layer. The protective layer 160 may include an organic material, an inorganic material, or an organic-inorganic material, for example, a (meth) acrylic polymer, polyimide, polyamide, poly(amide-imide), or a combination thereof, but is not limited thereto. The protective layer 160 may be formed of one or two or three or more layers.

In an embodiment, one of the first electrode 1, 10 and the second electrode 5, 50, may be a pixel electrode linked to the TFT and the other of them may be a common electrode.

In an embodiment, the electroluminescent device or the display device including the same may be used in a top emission type, a bottom emission type, a dual emission type, or a combination thereof.

In an embodiment, the first electrode 1, 10 may be a light transmitting electrode and the second electrode 5, 50 may be a reflective electrode, and the display panel may be a bottom emission type display panel that emits light toward the first electrode 10 and the substrate 100, if present. In an embodiment, the first electrode 1, 10 may be a reflective electrode and the second electrode 5, 50 may be a light transmitting electrode, and the display panel may be a top emission type display panel that emits light to the opposite side of the first electrode 10 and the substrate 100 if present. In one embodiment, both the first electrode and the second electrode may be translucent electrodes, and the display panel 1000 may be a both side emission type display panel that emits light on the substrate side and on the opposite side of the substrate.

The display device or an electronic apparatus may include (or may be) an augmented reality (AR) device, a (virtual reality) VR device, a handheld terminal (e.g., device), a monitor, a notebook computer, a television, an electronic display board, a camera, an electronic display component for an automatic vehicle, or an electric car.

Hereinafter, an embodiment is illustrated in more detail with reference to examples. However, these examples are exemplary, and the present scope is not limited thereto.

Examples

Analysis Method

1. Electroluminescence Measurement

A current according to an applied voltage was measured with a Keithley 2635B source meter, and a CS2000 spectrometer was used to measure electroluminescent properties (e.g., luminance and EQE) of a light-emitting device.

2. Life-span Characteristics

(1) T50: The device was initially driven at a predetermined luminance (e.g., 650 nit) and a time taken for a luminance of the given device to decrease to 50% of its initial luminance was measured.

(2) T90: The device was initially driven at a predetermined luminance (e.g., 650 nit) and a time taken for a luminance of the given device to decrease to 90% of its initial luminance was measured.

(3) An initial voltage is the first voltage of a device measured as the device is operated at a predetermined luminance for the measurement of the life-span thereof.

3. XPS Analysis

XPS analysis was conducted using X-ray photoelectron spectrometer (manufacturer: Physical Electronics, model name: Quantum2000).

4. ICP-AES Analysis

Inductively coupled plasma atomic emission spectroscopy (ICP-AES) analysis was performed using a Shimadzu ICPS-8100.

5. TEM analysis

A transmission electron microscopic analysis of the prepared nanoparticles was conducted using an UT F30 Tecnai electron microscope.

6. Photoluminescence Analysis

Photoluminescence (PL) analysis was conducted using a Hitachi F-7100 spectrophotometer.

7. UV-Vis Spectroscopy

A UV-Visible absorption spectroscopic analysis was conducted using a Shimadzu UV-2600 spectrophotometer and provided a UV-Visible absorption spectrum. The bandgap energy was obtained from the X-intercept value of the UV-Visible absorption spectrum based on the following equation:

$$\text{Bandgap energy (eV)} = 1240\text{(nm)} / \text{a X-intercept value (nm)}$$

8. TGA analysis

A thermogravimetric analysis was conducted under a $N_2$ atmosphere using a Trios V3.2 system (TA Instruments) at a heating rate of 10 degrees Celsius per minute (°C/min) from 20 °C to 600 °C.

9. Dynamic Light Scattering (DLS) Analysis

DLS analysis was performed using Otsuka, ELSZ-2000.

The following syntheses were performed under an inert gas atmosphere (e.g., under nitrogen) unless otherwise specified. A precursor content is provided as a molar content, unless otherwise specified.

Synthesis Example 1:

A Se/trioctylphosphine (TOP) stock solution [2 moles per liter (M)], a S/TOP stock solution (1 M), and a Te/TOP stock solution (0.1 M) were prepared by dispersing selenium (Se), sulfur (S), and tellurium (Te) in trioctylphosphine (TOP), respectively. In a reactor containing trioctylamine, 0.125 millimoles (mmol) of zinc acetate was added to the reactor with oleic acid and heated at 120 °C under reduced pressure (e.g., under vacuum). After 1 hour, nitrogen was introduced into the reactor.

The reactor was heated to 240 °C, and the Se/TOP stock solution and the Te/TOP stock solution in a Te:Se mole ratio of 1:15 were rapidly added to the reactor. When the reaction was complete, the reaction mixture was rapidly cooled to room temperature, and acetone was added to facilitate formation of a precipitate. The mixture (suspension) was centrifuged to separate the solids, and then the solids were dispersed in toluene to provide a ZnSeTe core (dispersion in toluene).

Zinc acetate [1.8 millimoles (mmol)] were added together with oleic acid to a flask containing trioctylamine and the mixture was heated at 120 °C under reduced pressure for 10 minutes. Nitrogen ($N_2$) was then introduced into the reactor, the reactor was heated to 220 °C. The prepared ZnTeSe core particle dispersion was added quickly to the reactor, and the Se/TOP stock solution and the S/TOP stock solution in a Se:S mole ratio of 1:2 are also added to the reactor, and the reactor temperature was raised to about 280 °C. After 2 hours, the reactor was cooled to room temperature and ethanol was added to precipitate the semiconductor nanoparticles, which were separated by centrifugation.

The prepared semiconductor nanoparticles emit blue light of about 460 nanometers (nm).

Preparation Example 1(ZnMgO:$Rb_2CO_3$ 5%):

Rubidium carbonate (Cas No. 584-09-8) was dissolved in ethanol to provide a 0.1M metal carbonate solution. Tetramethylammonium hydroxide (first base) was dissolved in ethanol to provide a 0.55 M base solution.

In a flask containing dimethyl sulfoxide, zinc acetate dihydrate (powder) and magnesium acetate tetrahydrate (powder) were added and dissolved, and the base solution and the metal carbonate solution were added thereto and stirred at room temperature for 60 minutes.

Ethyl acetate was added to precipitate the particles, and the formed precipitate was centrifuged. The obtained particles were washed two or more times with ethyl acetate to provide a zinc oxide nanoparticle including magnesium (i.e., zinc magnesium oxide nanoparticle, also referred to as ZnMgO). The obtained nanoparticle was red-dispersed in ethanol and subjected to transmission electron microscope analysis. The size of the zinc magnesium oxide nanoparticle was calculated to be about 3 nm to 4.5 nm.

The molar ratio between the magnesium precursor and the zinc precursor was 0.15:0.85. The metal carbonate content was 5 mol% based on the Zn content (5 mol per 100 mol of Zn).

An UV-Vis absorption spectroscopy analysis, a DLS analysis, and a TGA analysis were performed on the obtained nanoparticles, and the results are shown in FIGS. 4, 5A, and 5B.

A photoluminescence analysis (e.g., defect emission peaks) was performed on the obtained zinc oxide nanoparticles and the results thereof are shown in FIG. 6.

An XPS analysis was performed on the obtained zinc oxide nanoparticles and the results are shown in FIG. 7 and Table 2.

An ICP-AES analysis was performed on the obtained zinc oxide nanoparticles, and the results are summarized in Table 3.

Comparative Preparation Example 1:

A zinc oxide nanoparticle (pristine ZnMgO) was manufactured in the same manner as in Preparation Example 1, except that a rubidium carbonate solution was not used.

Preparation Example 2(ZnMgO:Ga+ $Rb_2CO_3$ 5%):

Potassium hydroxide (second base) was dissolved in ethanol to provide a 0.4 M base solution. Rubidium carbonate was dissolved in ethanol to provide a metal carbonate solution.

A mixed solvent obtained by mixing ethanol (relative polarity: 0.654) and cyclohexane (relative polarity: 0.006) in a ratio of 1:1 (volume) was added to a flask and stirred. Zinc acetate dihydrate (powder) and magnesium acetate tetrahydrate (powder) were added to the flask and dissolved by heating up to 55°C in a nitrogen atmosphere, and then the base solution and the metal carbonate solution were added to the flask and stirred at 30°C for 60 minutes.

Ethyl acetate was added to the reaction solution to precipitate the particles, and the formed precipitate was centrifuged. The obtained particles were washed with ethyl acetate two or more times to provide ZnMgO nanoparticles (i.e. prepared by LSS method, hereinafter, a first nanoparticle). The obtained nanoparticles were re-dispersed in ethanol and a transmission electron microscope analysis was conducted. The average size of the particle was calculated to be about 3 nm.

Gallium chloride was dissolved in ethanol to provide a gallium precursor solution. Tetramethylammonium hydroxide (first base) was dissolved in ethanol to provide a 0.55M base solution. Ethanol and the first nanoparticle synthesized above were added to the flask and dispersed, and the temperature was maintained at 30°C. The gallium precursor solution and the base solution were added to the flask, and the reaction was allowed to proceed for 60 minutes. The content of gallium used was 5 mol% based on zinc used in the preparation of the first nanoparticles. After completion of the reaction, ethyl acetate (EA) was added to precipitate the nanoparticles, and the nanoparticles were separated and washed two or more times to provide a zinc oxide nanoparticle including magnesium and gallium.

An UV-Vis absorption spectroscopy analysis, a DLS analysis, and a TGA analysis were performed on the obtained nanoparticle, and the results are shown in FIGS. 4, 5A, and 5B.

Preparation Example 3 (ZMO:$Rb_2CO_3$ 8%):

A zinc oxide nanoparticle was prepared in the same manner as in Preparation Example 1, except that the content of rubidium carbonate was changed to 8 mol% based on the Zn content.

Preparation Example 4(ZMO:$Rb_2CO_3$ 10%):

A zinc oxide nanoparticle was prepared in the same manner as in Preparation Example 1, except that the content of rubidium carbonate was changed to 10 mol% based on the Zn content.

Table 1

| | Composition | UV-Vis first abs. peak (nm) | X intercept (nm) | DLS diameter (nm) | TGA Weight loss at 500 °C |
|---|---|---|---|---|---|
| Comp. Preparation Example 1 | ZMO | 308 | 332 | 6.9 nm | 21.3 wt% |
| Preparation Example 1 | ZMO:$Rb_2CO_3$ (5%) | 304 | 330 | 6.8 nm | 26.7 wt % |
| Preparation Example 2 | ZMO:Ga+$Rb_2CO_3$ (5%) | 300 | 325 | 5.2 nm | 32.2 wt % |

As shown in FIG. 4 and Table 1, the zinc oxide nanoparticles prepared in Preparation Example 1 and Preparation Example 2 have a first absorption peak of 305 nm or less and a clear valley.

From the results of Table 1, FIGS. 5A, and 5B, it is confirmed that the zinc oxide nanoparticle of Preparation Example 1 and Preparation Example 2 exhibit a decomposition pattern different from that of the zinc oxide nanoparticle of Comparative Preparation Example 1 prepared without using the metal carbonate and also have a relatively high TGA residue content. The results indicate that the zinc oxide nanoparticles prepared in Preparation Example 1 and Preparation Example 2 may have an increased amount of the surface ligand in comparison to the zinc oxide particle of Preparation Comparative Example 1. Without wishing to be bound by theory, it is believed that this is because not only -OH and $CH_3COO$- groups but also carbonate ions serve to passivate the Zn dangling bond on the surface of the particle in the zinc oxide nanoparticles of Preparation Example 1 and Preparation Example 2. The DTG data shown in FIG. 5B suggests that the decomposition pattern (or degree of decomposition) of the carbonaceous functional group in the zinc oxide nanoparticles of Preparation Example 1 and Preparation Example 2 is different from that of the zinc oxide nanoparticles of Preparation Comparative Example 1. Without wishing to be bound by theory, the difference in DTG data shown in FIG. 5B may be due to the binding of carbonate ion to the zinc oxide nanoparticles prepared in Preparation Example 1 and Preparation Example 2.

As shown in the photoluminescence analysis results of FIG. 6, the zinc oxide nanoparticle produced in Preparation Example 1 exhibits a significantly lower level of trap luminescence intensity than the zinc oxide nanoparticle produced in Preparation Comparative Example 1. Without wishing to be bound by theory, it is believed that a decrease in trap emission may be caused by the binding of carbonate ions on the surface of the metal oxide nanoparticle.

FIG. 7A shows an O1s XPS spectrum of the zinc oxide nanoparticle of Preparation Example 1 and an O1s XPS spectrum (i.e., O1s peak) of a sample obtained by simply blending $Rb_2CO_3$ into the zinc oxide nanoparticle of Preparation Comparative Example 1. FIG. 7B shows a Zn2p XPS spectrum of the zinc oxide nanoparticle of Preparation Example 1 and a Zn2p XPS spectrum (i.e., Zn2p peak) of a sample obtained by simply blending $Rb_2CO_3$ into the zinc oxide nanoparticle of Preparation Comparative Example 1.

As shown in Fig. 7A, the zinc oxide nanoparticles of Preparation Example 1 and the sample obtained by simply blending $Rb_2CO_3$ into the zinc oxide nanoparticles of Comparative Preparation Example 1 have a peak (first peak) in the range of approximately 532 eV to 533 eV, and exhibit the lattice oxygen peak (second peak) of metal oxides at 531 eV. However, the zinc oxide nanoparticles of Preparation Example 1 shows a significantly decreased intensity of the second peak compared to the intensity of the first peak, and thus the full width at half maximum (FWHM) and the full width at half maximum (HWHM) of the Os1 peak are less than 3.0 eV and less than 2.0 eV, respectively. In contrast, in the case of the sample containing the zinc oxide nanoparticle of Comparative Preparation Example 1, the intensity of the second peak is remarkably increased, and the intensity ratio of the second peak to the intensity of the first peak is high, and it is confirmed that the full width at half maximum (FWHM) and the full width at half maximum (HWHM) of the Os1 peak are greater than 3.0 eV and greater than 2.0 eV, respectively. Without wishing to be bound by theory, it is believed that when carbonate ions are provided in the synthesis step under the conditions specified in the zinc oxide nanoparticles prepared in Preparation Example 1, the particle surface metal oxide lattice oxygen may decrease and the provided carbonate ions may bind via hydrogen bonds on the Zn-OH surface.

As shown in FIG. 7B, in case of the zinc oxide nanoparticles of Preparation Example 1, the Zn2p peak is shifted toward a lower binding energy, and thus is shown in a range lower than 1045 eV. Without wishing to be bound by theory, the result may indicate that the carbonate ions provide passivation for Zn dangling bonds on a surface of the particle in the form of bridging, chelating, or monodentate adsorption in case of the zinc oxide nanoparticles of Preparation Example 1.

Table 2

| | O1s peak's FWHM | O1s peak's HWHM | An intensity ratio at 530 eV with respect to a maximum intensity |
|---|---|---|---|
| Preparation Example 1 | 2.1 eV | 1.1 eV | 0.11 |
| Comp. Preparation Example 1 | 3.1 eV | 2.0 eV | 0.22 |

Without wishing to be bound by theory, it is believed that when an alkali metal carbonate precursor is added during the ZnMgO synthesis of the preparation examples, the adsorption of carbonate to the surface of ZnMgO may change the composition/aspect of the surface ligand in comparison with pristine ZnMgO, and accordingly, the binding of the peripheral carbonaceous functional groups on the obtained particle may also be changed.

Table 3

| | Zn | Mg |
|---|---|---|
| Preparation Example 1 | About 0.88 | About 0.12 |
| Comp. Preparation Example 1 | About 0.88 | About 0.12 |

As shown in Table 3, there is no significant difference between the molar compositions of zinc and magnesium in the particles of the Preparation Example 1 and Comparative Preparation Example 1.

Manufacture of Electroluminescent Devices

Example 1

A semiconductor nanoparticle solution was prepared by dispersing the semiconductor nanoparticles prepared in Synthesis Example 1 in octane. An ETL dispersion was prepared by dispersing the zinc oxide nanoparticles prepared in Preparation Example 1 in ethanol.

An electroluminescent device (ITO/PEDOT:PSS (35 nm)/TFB (25 nm)/QD light emitting layer (20 nm)/ETL (20 nm)/Al (100 nm)) was produced according to the following method.

After surface-treating a glass substrate deposited with ITO with UV-ozone for 15 minutes, a PEDOT:PSS solution (H.C. Starks, Inc.) is spin-coated thereon and heat-treated at 150 °C for 10 minutes under an air atmosphere and then, at 150 °C for 20 to 30 minutes under an $N_2$ atmosphere to form a 35 nm-thick hole injection layer.

On the hole injection layer, a poly[(9,9-dioctylfluoren-2,7-diyl-co-(4,4'-(N-4-butylphenyl)diphenylamine] solution (TFB) (Sumitomo Corp.) is spin-coated and heat-treated at 150 °C for 30 minutes, forming a 25 nm-thick hole transport layer.

On the hole transport layer, the semiconductor nanoparticle solution is spin-coated to form a 20 nm-thick light emitting layer.

On the light emitting layer, the ETL dispersion is spin-coated and heat-treated for 30 minutes, forming an electron transport layer (thickness: 20 nm).

On the obtained electron transport layer, aluminum (Al) is vacuum-deposited (thickness: 100 nm), forming a second electrode and thus producing an electroluminescent device.

The electroluminescence properties and lifespan of the manufactured electroluminescence devices were measured, and the results thereof are summarized in Table 4. The maximum external quantum efficiency (Max EQE) of the manufactured electroluminescence device was 9.4%.

Example 2

An electroluminescent device was manufactured in the same manner as in Example 1, except that the zinc oxide nanoparticle prepared in Preparation Example 2 were used.

The electroluminescence properties and lifetime of the manufactured electroluminescence devices were measured, and the results thereof are summarized in Table 4. The maximum external quantum efficiency (Max EQE) of the manufactured electroluminescence device was 10.3%.

Example 3

An electroluminescent device was manufactured in the same manner as in Example 1, except that the zinc oxide nanoparticle prepared in Preparation Example 3 was used.

The electroluminescent properties and lifespan of the manufactured electroluminescent device were measured, and the results are summarized in Table 4.

Example 4

An electroluminescent device was manufactured in the same manner as in Example 1, except that the zinc oxide nanoparticle prepared in Preparation Example 4 was used.

The electroluminescent properties and lifespan of the manufactured electroluminescent device were measured, and the results are summarized in Table 4.

Comparative Example 1

An electroluminescent device was manufactured according to the same method as Example 1 except the nanoparticle manufactured in Comparative Preparation Example 1 was used. Electroluminescence properties and lifetime of the electroluminescent device were measured, and the results thereof are summarized in Table 4.

The maximum external quantum efficiency (Max EQE) of the manufactured electroluminescent device was 8.1 %.

Table 4

| | Nanoparticle in the ETL | Max. Luminance Cd/$m^2$ | T90 (hour) | T50 (hour) | Initial Voltage (volt) |
|---|---|---|---|---|---|
| Comp. Example 1 | Comp. Preparation Example 1 ZnMgO | 84927 | 58 | 255 | 2.8 |
| Example 1 | Preparation Example 1 ZnMgO:$Rb_2CO_3$ (5%) | 87951 | 80.69 | 431.31 | 2.8 |
| Example 3 | Preparation Example 3 ZnMgO:$Rb_2CO_3$ (8%) | 86459 | 100.76 | 391.19 | 2.8 |
| Example 4 | Preparation Example 4 ZnMgO:$Rb_2CO_3$ (10%) | 94389 | 113.06 | 387.15 | 2.77 |
| Example 2 | Preparation Example 2 ZMO: Ga+$Rb_2C$ $O_3$(5%) | About 85000 | 84.79 | 561 | 2.8 |

As shown in Table 4, the electroluminescent devices of the examples exhibit improved electroluminescent properties and extended lifespan characteristics compared to the electroluminescent device of Comparative Example 1. The leakage current was determined by measuring the current density according to the applied voltage for the electroluminescent device of Comparative Example 1, the electroluminescent device of Example 1, and the electroluminescent device of Example 2. The results are shown in FIG. 8. As shown in FIG. 8, the leakage current in the electroluminescent device of the embodiment is significantly smaller than that of the electroluminescent device of the comparative example.

Experimental Example 1

A semiconductor nanoparticle solution prepared by dispersing semiconductor nanoparticles prepared in Synthesis Example 1 in octane was prepared. The zinc oxide nanoparticle prepared in Preparation Example 1 were dispersed in ethanol to provide an ETL dispersion 1. The zinc oxide nanoparticle prepared in Comparative Preparation Example 1 was dispersed in ethanol to provide an ETL dispersion 2.

In the same manner as in Example 1, on a glass substrate, a light emitting layer was formed using a semiconductor nanoparticle solution, and on the formed light emitting layer, an electron transport layer was disposed using an ETL dispersion 1 to provide Stacked Structure 1. Similarly, in the same manner as in Example 1, on a glass substrate, a light emitting layer was formed using a semiconductor nanoparticle solution, and an electron transport layer was formed on the formed light emitting layer using an ETL dispersion 2 to provide Stacked Structure 2. In the same manner as in Example 1, on a glass substrate, a light emitting layer was formed using a semiconductor nanoparticle solution to provide Stacked Structure 3.

A photoluminescence analysis was performed on each of stacked structure 1 (Glass/QD/Manufacturing Example 1 ZnMgO), stacked structure 2 (Glass/QD/Manufacturing Comparative Example 1 ZnMgO), and stacked structure 3 (Glass/QD), and the results thereof are shown in FIG. 9.

As shown in FIG. 9, the Stacked Structure 2 exhibits a remarkable PL quenching phenomenon compared to Stacked Structure 3, which is believed to be due to the Trap and FRET effects, without wishing to be bound by any theory. In contrast, Stacked Structure 1 exhibits increased PL emission in comparison to Stacked Structure 3.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims.

## Claims

**1.** A method of producing an electroluminescent device, which comprises:

disposing a light emitting layer including a semiconductor nanoparticle on a first electrode;
providing a zinc oxide nanoparticle;
depositing a composition comprising the zinc oxide nanoparticle onto the light emitting layer to provide an electron transport layer, the zinc oxide nanoparticle comprises a first metal; and
disposing a second electrode on the electron transport layer to provide the electroluminescent device,
wherein the first metal comprises an alkaline earth metal, zirconium, tungsten, titanium, yttrium, aluminum, gallium, indium, tin, cobalt, vanadium, or a combination thereof,
wherein the zinc oxide nanoparticle has a particle size of greater than or equal to 1 nanometer and less than or equal to 50 nanometers,
wherein the providing the zinc oxide nanoparticle includes
contacting a first metal precursor, a zinc precursor, a base, and a metal carbonate compound in an organic solvent to form the zinc oxide nanoparticle.

**2.** The method of claim 1, wherein the first metal comprises magnesium, zirconium, tungsten, titanium, yttrium, aluminum, gallium, indium, tin, cobalt, vanadium, or a combination thereof.

**3.** The method of claims 1 or 2, wherein the providing the zinc oxide nanoparticle comprises dissolving the first metal precursor and the zinc precursor in the organic solvent to provide a first solution;

adding the base and the metal carbonate compound to the organic solvent before dissolving the first metal precursor and the zinc precursor in the organic solvent or adding the base and the metal carbonate compound to the first solution; and
allowing the zinc precursor and the first metal precursor to react in the presence of the base and the metal carbonate compound.

**4.** The method of any of claims 1-3, wherein as determined by X-ray Photoelectron Spectroscopy analysis, the electron transport layer does not exhibit a peak assigned to rubidium, cesium, or a combination thereof; and/or
wherein the organic solvent is a solvent mixture including a first solvent and a second solvent, and a relative polarity difference between the first solvent and the second solvent is greater than or equal to 0.3 and less than or equal to 0.9.

**5.** The method of any of claims 1-4, wherein the base comprises a first base, a second base, or a combination thereof,

the first base comprises an organic base containing a C1 to C50 organic group, and
the second base comprises an inorganic base containing an alkali metal or an alkaline earth metal;
preferably wherein

the base comprises the second base,
the second base comprises an alkali metal hydroxide, and
wherein a molar ratio between the second base and the first base (second base : first base) is from 1:0 to 1:10.

**6.** The method of any of claims 1-5, wherein the metal carbonate compound comprises an alkali metal carbonate, an alkali metal bicarbonate, an alkaline earth metal carbonate, or a combination thereof; and/or
wherein the base comprises a C1 to C30 alkylammonium hydroxide compound, an alkali metal hydroxide, or a combination thereof, and the metal carbonate compound comprises rubidium carbonate, rubidium bicarbonate, cesium carbonate, cesium bicarbonate, or a combination thereof.

**7.** The method of any of claims 1-6, wherein the zinc oxide nanoparticle has a core-shell structure and the providing of the zinc oxide nanoparticle having the core shell structure further comprises:

dispersing the formed zinc oxide nanoparticle in a third solvent;
adding an additional metal precursor and a third base to the third solvent and reacting the additional metal precursor and the third base to form an additional metal-containing layer on the formed zinc oxide nanoparticle, and
wherein the additional metal is different from the first metal and comprises an alkaline earth metal, zirconium, tungsten, titanium, yttrium, aluminum, gallium, indium, tin, cobalt, vanadium, or a combination thereof.

**8.** The method of any of claims 1-7, wherein the composition does not comprise cesium carbonate, rubidium carbonate, lithium carbonate, sodium carbonate, potassium carbonate, or a combination thereof.

**9.** An electroluminescent device comprising:

a first electrode and a second electrode spaced apart from each other; and
a light emitting layer disposed between the first electrode and the second electrode; and
an electron transport layer disposed between the light emitting layer and the second electrode,
wherein the light emitting layer includes a semiconductor nanoparticle,
wherein the electron transport layer includes a zinc oxide nanoparticle,
wherein the zinc oxide nanoparticle comprises a first metal, and the first metal comprises an alkaline earth metal; and optionally zirconium, tungsten, titanium, yttrium, aluminum, gallium, indium, tin, cobalt, vanadium, or a combination thereof,
wherein the zinc oxide nanoparticle has a size of greater than or equal to 1 nanometer and less than or equal to 50 nanometers,
wherein in X-ray Photoelectron Spectroscopy analysis of the zinc oxide nanoparticle, an O1s peak has a full width at half maximum of less than or equal to 3 electronvolts,
wherein the light emitting layer is configured to emit a blue light,
wherein the electroluminescent device is configured to exhibit a maximum luminance of greater than or equal to 60,000 candela per square meter.

**10.** The electroluminescent device of claim 9, wherein the O1s peak has a half width at half maximum (HWHM) of less than or equal to about 2.5 electronvolts.

**11.** The electroluminescent device of claims 9 or 10, wherein in the O1s peak has a ratio of an intensity at 530 electronvolts to a maximum intensity is less than or equal to 0.3:1; and/or
wherein as determined by X-ray Photoelectron Spectroscopy analysis, the electron transport layer does not exhibit a peak assigned to rubidium, cesium, or a combination thereof.

**12.** The electroluminescent device of any of claims 9-11, wherein the zinc oxide nanoparticle comprises magnesium and gallium,
wherein in the zinc oxide nanoparticle, an amount of gallium is greater than or equal to 3 mole percent and less than or equal to 25 mole percent based on total moles of zinc, magnesium, and gallium.

**13.** The electroluminescent device of any of claims 9-12, wherein in X-ray Photoelectron Spectroscopy analysis of the zinc oxide nanoparticle, an O1s X-ray Photoelectron Spectroscopy intensity spectrum has a full width at half maximum of less than or equal to 2.5 electronvolts and a half width at half maximum of less than or equal to 1.9 electronvolts.

**14.** The electroluminescent device of any of claims 9-13, wherein

the electroluminescent device has a maximum external quantum efficiency of greater than or equal to 6 percent, or
the electroluminescent device exhibits a T90 of greater than or equal to 255 hours as measured at an initial luminance of 650 nit.

**15.** A display device comprising the electroluminescent device of any of claims 9-14;
preferably wherein the display device comprises a handheld terminal device, a monitor, a notebook computer, a television, an electronic display board, a camera, or an electronic component for an automatic vehicle.

FIG. 1

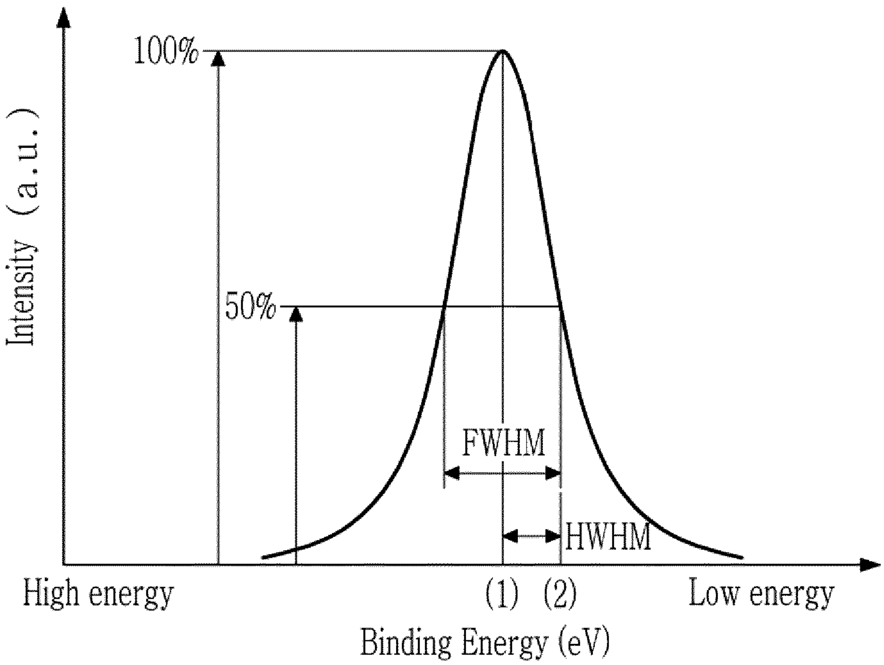
100%
50%
Intensity (a.u.)
FWHM
HWHM
High energy
(1)
(2)
Low energy
Binding Energy (eV)

FIG. 2

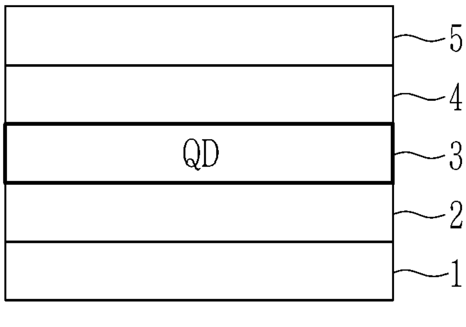

FIG. 3A

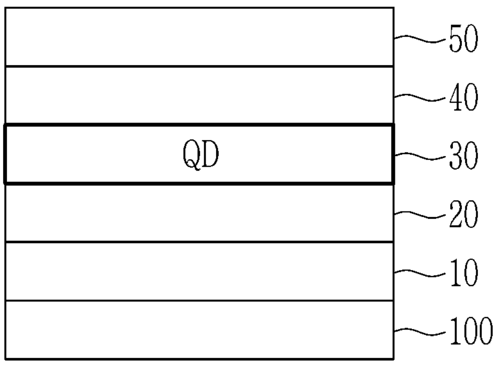

FIG. 3B

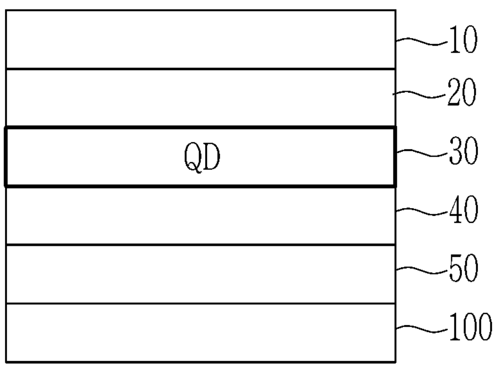

FIG. 3C

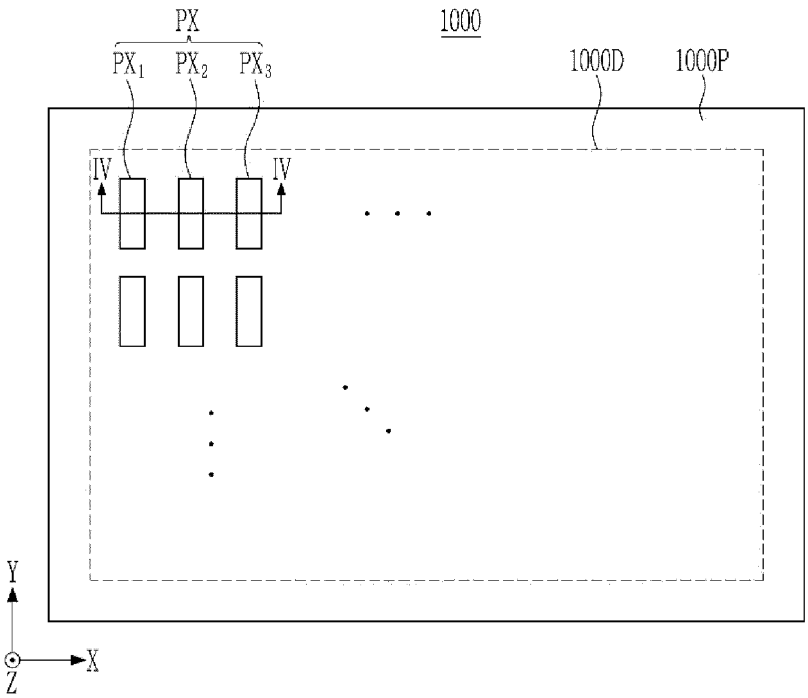
PX
PX1
PX2
PX3
1000
1000D
1000P
IV
IV
Y
X
Z

FIG. 3D

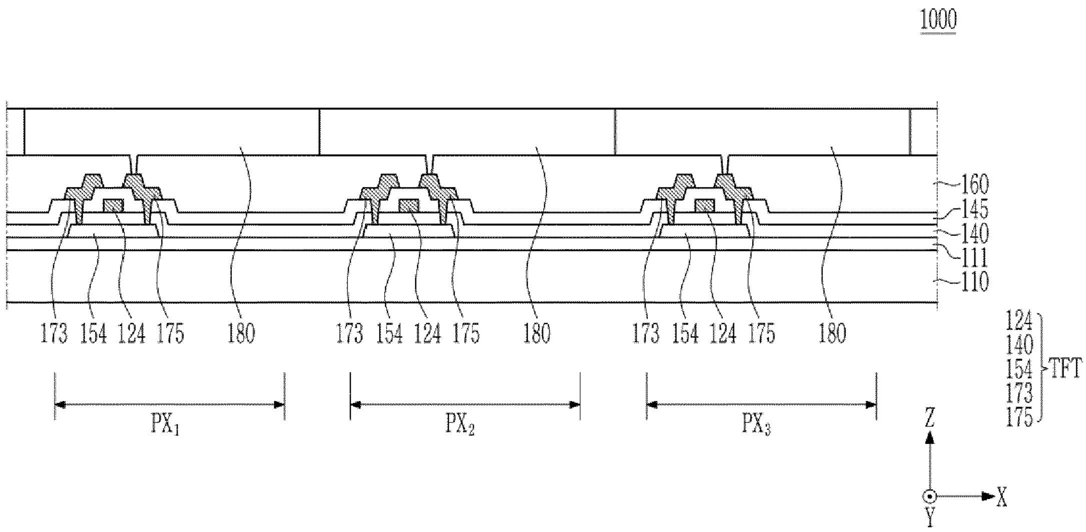
1000
160
145
140
111
110
173 154 124 175 180
173 154 124 175 180
173 154 124 175 180
PX1
PX2
PX3
124
140
154
173
175
TFT
Z
X
Y

FIG. 4

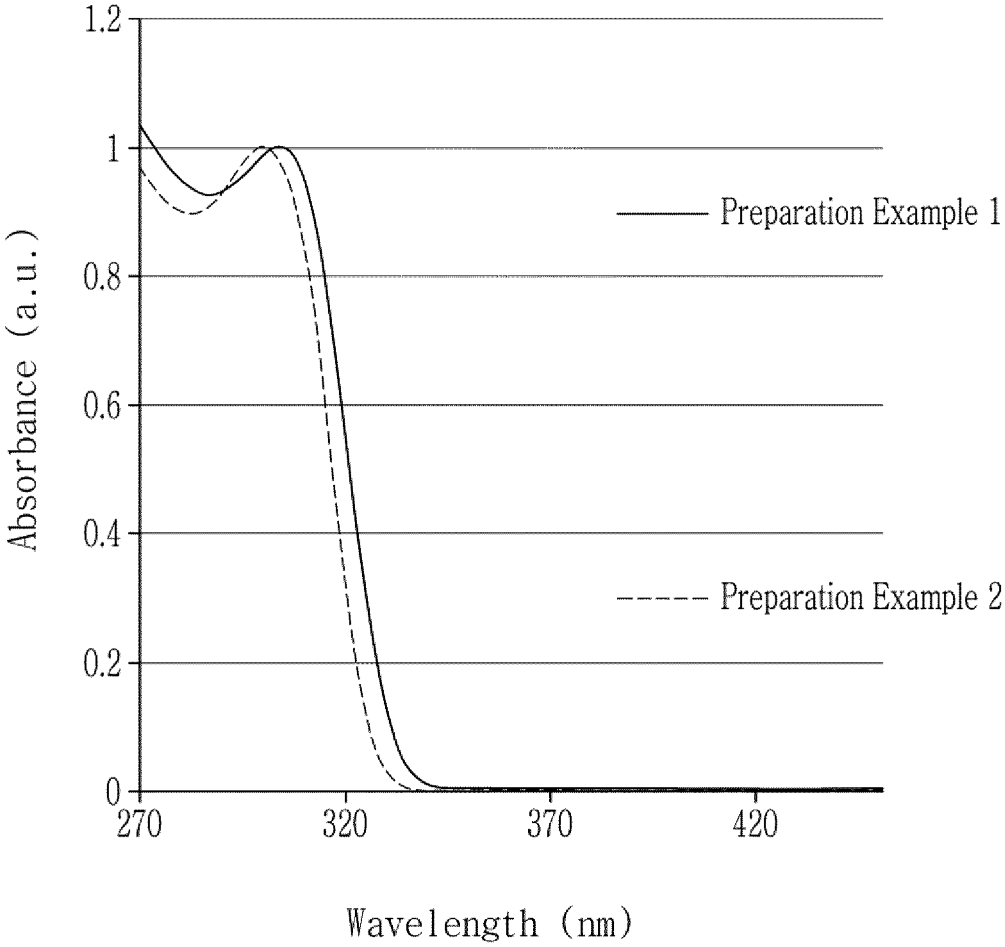
1.2
1
0.8
0.6
0.4
0.2
0
270
320
370
420
Absorbance (a.u.)
Wavelength (nm)
Preparation Example 1
Preparation Example 2

# FIG. 5A

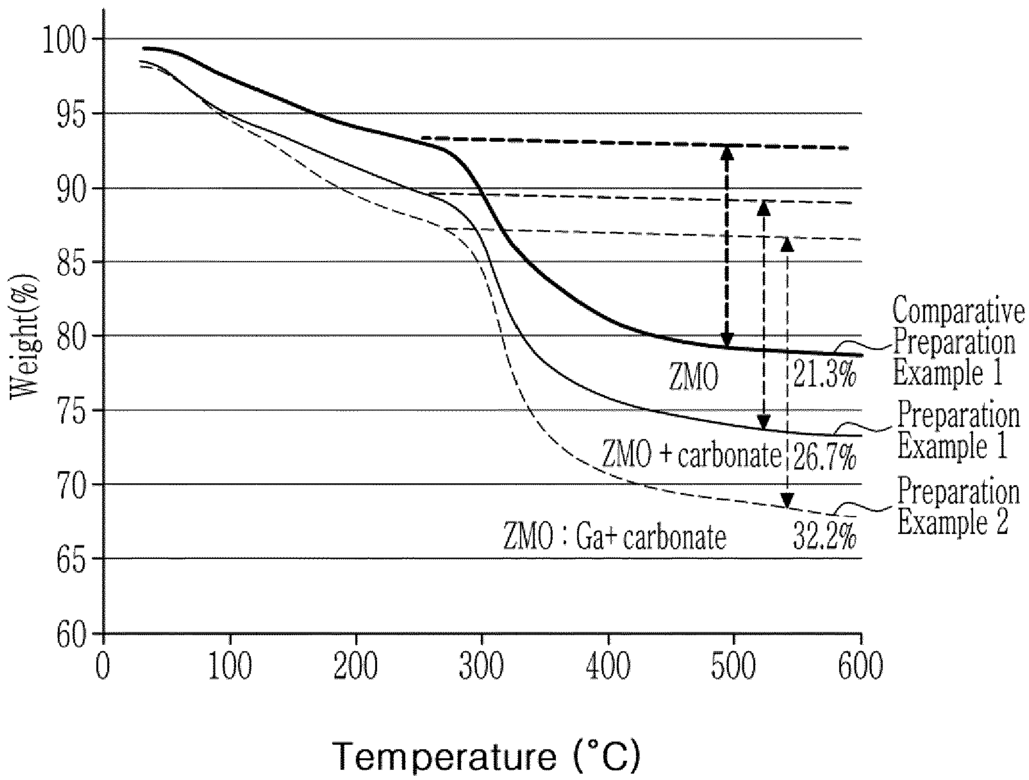
100
95
90
85
80
75
70
65
60
Weight(%)
0
100
200
300
400
500
600
Temperature (°C)
ZMO
21.3%
ZMO + carbonate
26.7%
ZMO : Ga+ carbonate
32.2%
Comparative Preparation Example 1
Preparation Example 1
Preparation Example 2

FIG. 5B

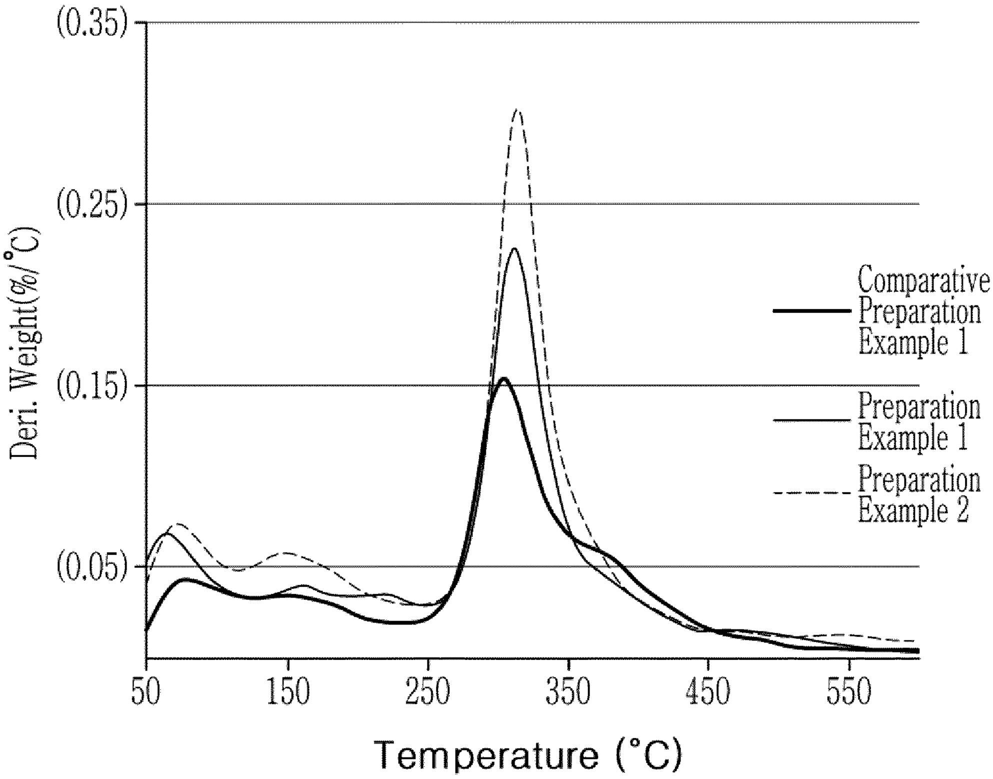
(0.35)
(0.25)
(0.15)
(0.05)
Deri. Weight(%/°C)
50
150
250
350
450
550
Temperature (°C)
Comparative Preparation Example 1
Preparation Example 1
Preparation Example 2

FIG. 6

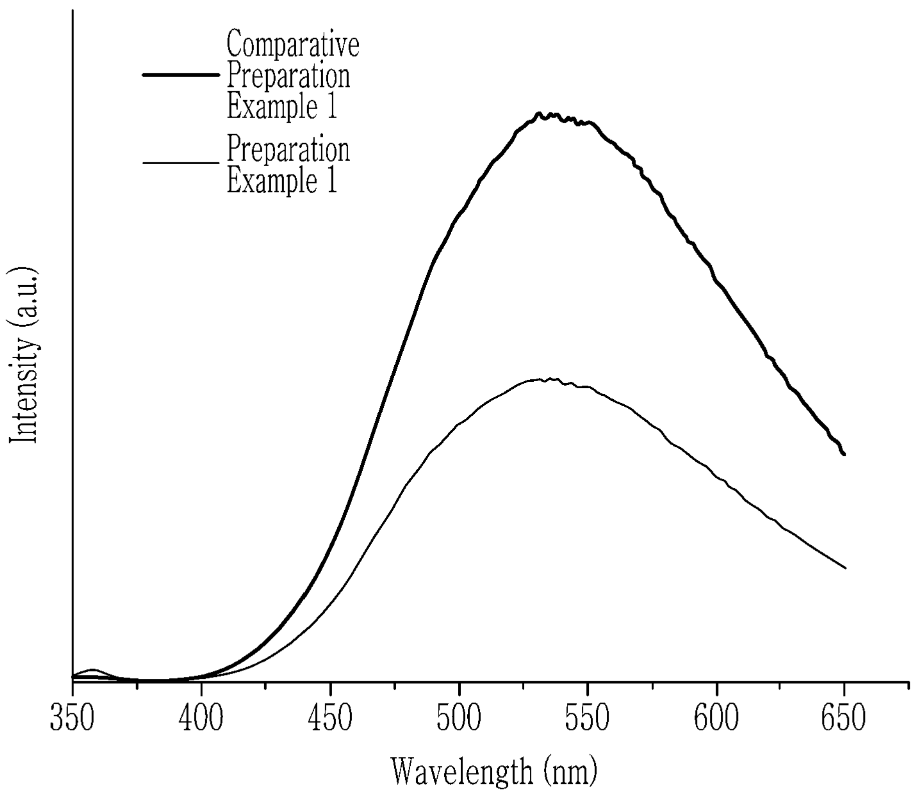
Comparative Preparation Example 1
Preparation Example 1
Intensity (a.u.)
350
400
450
500
550
600
650
Wavelength (nm)

# FIG. 7A

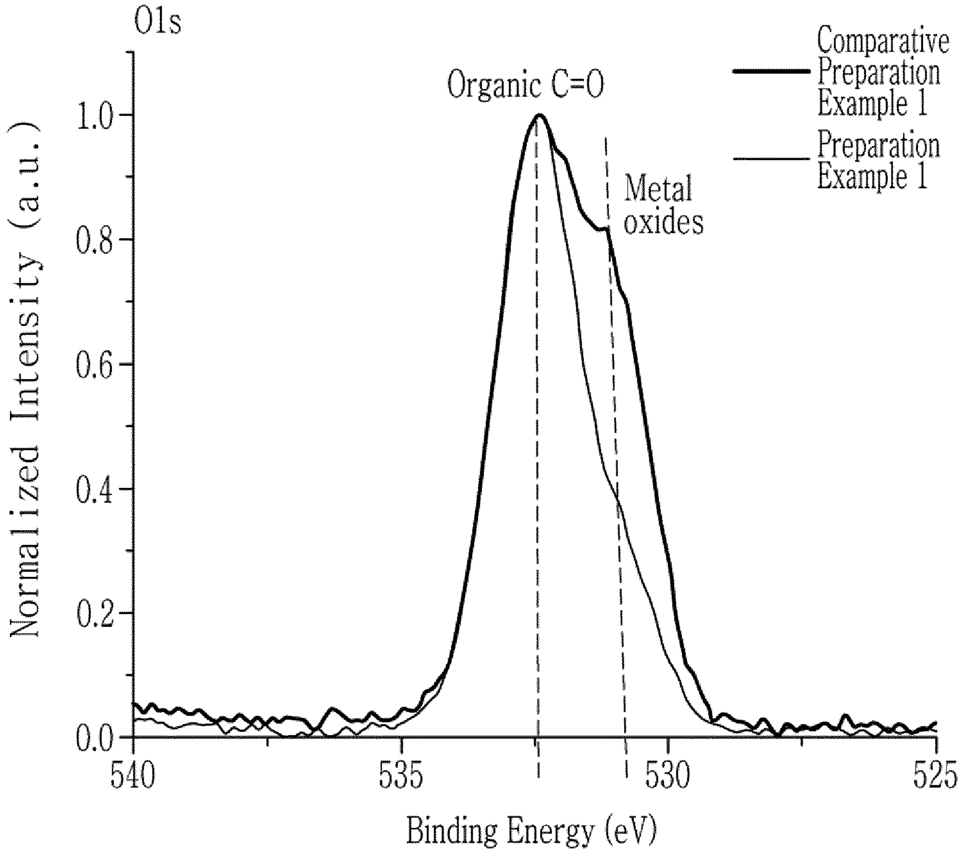
O1s
Organic C=O
Metal oxides
Comparative Preparation Example 1
Preparation Example 1
Normalized Intensity (a.u.)
1.0
0.8
0.6
0.4
0.2
0.0
540
535
530
525
Binding Energy (eV)

# FIG. 7B

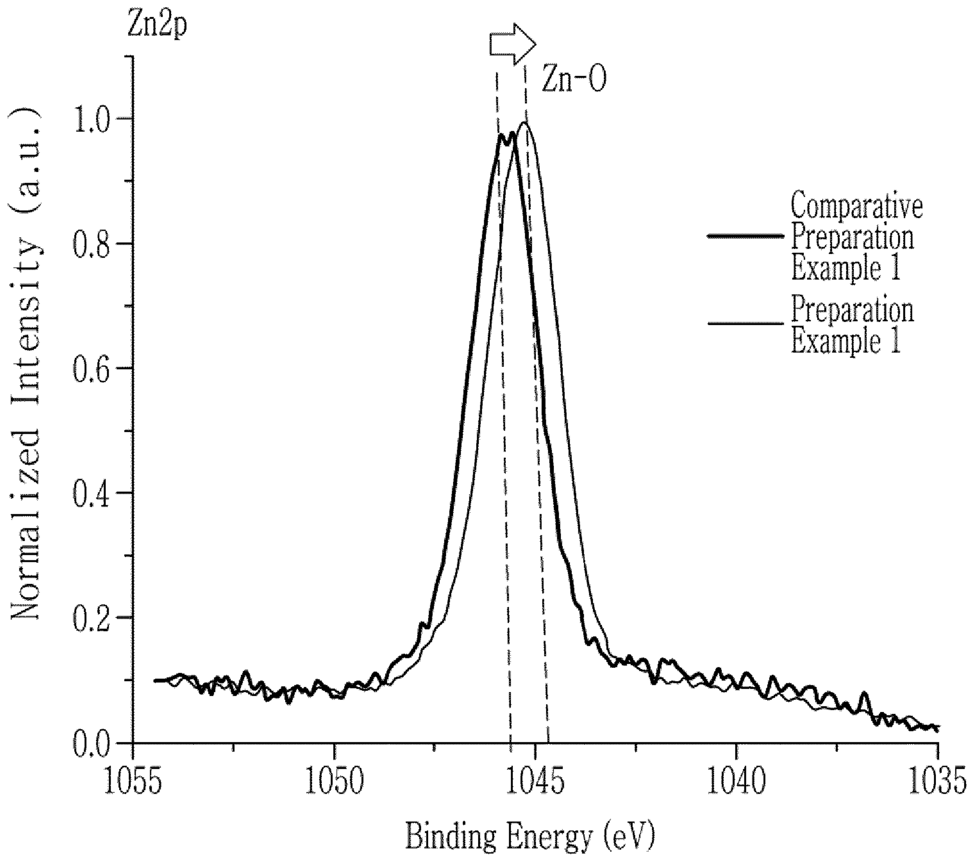
Zn2p
Zn-O
Normalized Intensity (a.u.)
1.0
0.8
0.6
0.4
0.2
0.0
1055
1050
1045
1040
1035
Binding Energy (eV)
Comparative Preparation Example 1
Preparation Example 1

FIG. 8

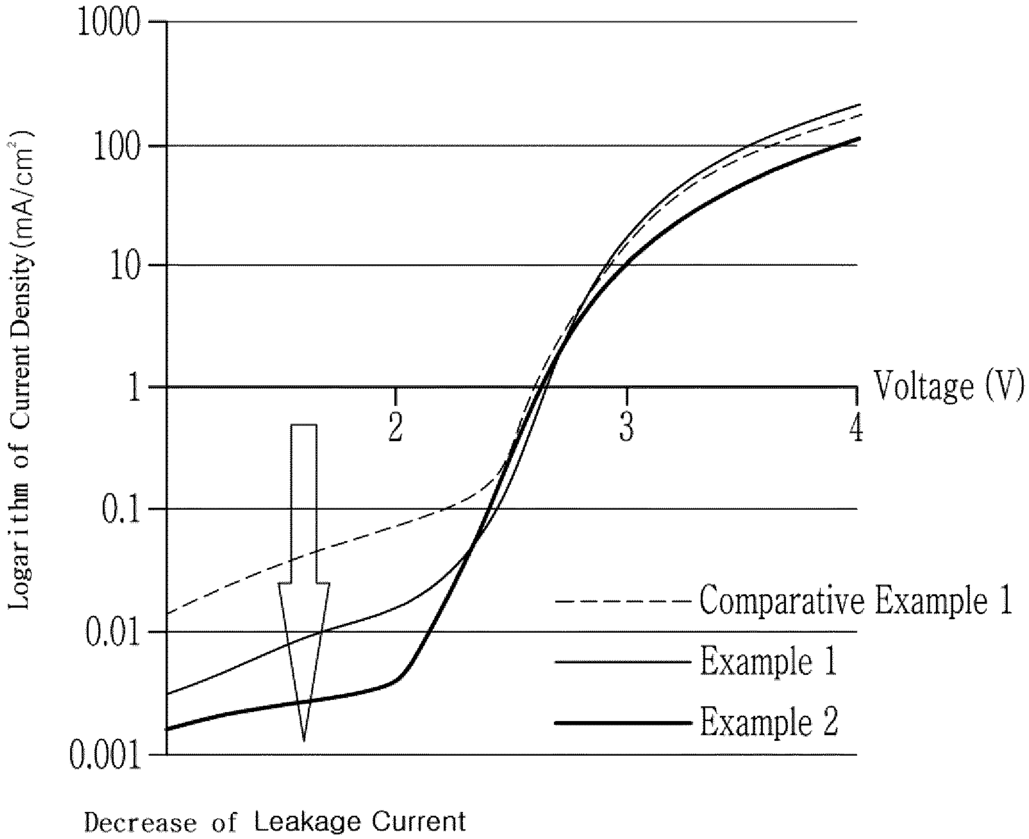
1000
100
10
1
0.1
0.01
0.001
Logarithm of Current Density (mA/cm²)
2
3
4
Voltage (V)
Comparative Example 1
Example 1
Example 2
Decrease of Leakage Current

FIG. 9

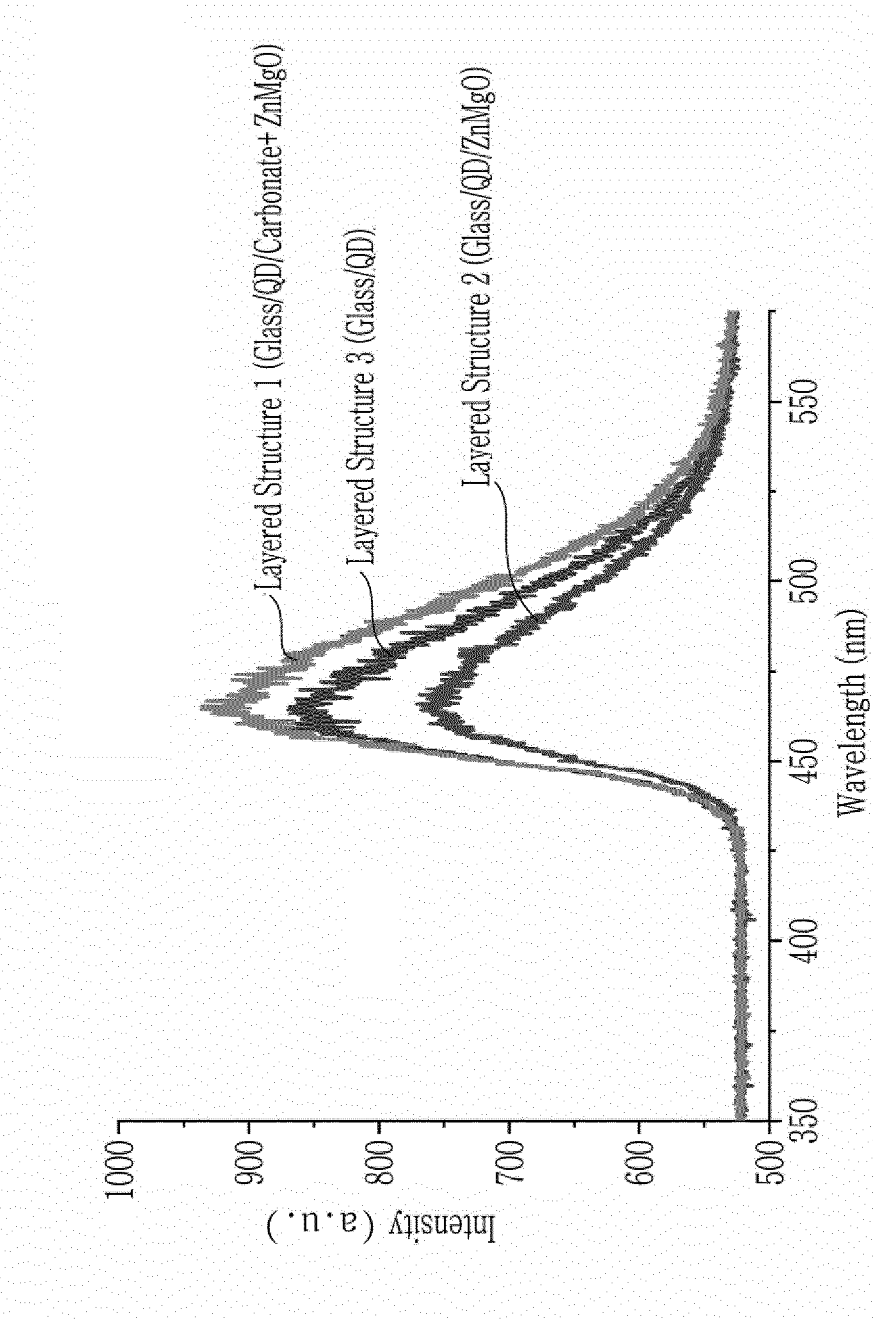
Layered Structure 1 (Glass/QD/Carbonate+ZnMgO)
Layered Structure 3 (Glass/QD)
Layered Structure 2 (Glass/QD/ZnMgO)
Intensity (a.u.)
1000
900
800
700
600
500
350
400
450
500
550
Wavelength (nm)

Europäisches Patentamt
European Patent Office
Office européen des brevets

# EUROPEAN SEARCH REPORT

Application Number
EP 24 17 5170

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KIM HYO-MIN ET AL: "Stability of Quantum-Dot Light Emitting Diodes with Alkali Metal Carbonates Blending in Mg Doped ZnO Electron Transport Layer", NANOMATERIALS, [Online] vol. 10, no. 12, 4 December 2020 (2020-12-04), page 2423, XP093208981, ISSN: 2079-4991, DOI: 10.3390/nano10122423 Retrieved from the Internet: URL:https://www.mdpi.com/2079-4991/10/12/2423/pdf> [retrieved on 2024-09-25] * the whole document * ----- | 1-15 | INV. H10K50/115 H10K50/16 |
| A | SEEMA ET AL: "Structural, morphological and dielectric behavior of Mg, Al, Ga/Mg and Al/Mg-doped ZnO nanoparticles: A comparative study", MATERIALS TODAY: PROCEEDINGS, [Online] 1 February 2023 (2023-02-01), XP093209521, NL ISSN: 2214-7853, DOI: 10.1016/j.matpr.2023.02.064 Retrieved from the Internet: URL:https://pdf.sciencedirectassets.com/305927/AIP/1-s2.0-S2214785323005849/main.pdf?X-Amz-Security-Token=IQoJb3JpZ2luX2VjEOD//////////wEaCXVzLWVhc3QtMSJHMEUCIFoR7yl6nQO2wSpDWFf5LqX3lKpKB8SF0uEIOy+PDR2BAiEAmw566q6uWym2BTiKeMxpUlmP5HFC9GO35k56kLKsQCMqswUIKRAFGgwwNTkwMDM1NDY4NjUiDI9j6g4HMaAj/IYdDCqQBTrwPg> [retrieved on 2024-09-25] * the whole document * ----- -/-- | 12 | TECHNICAL FIELDS SEARCHED (IPC) H10K |

The present search report has been drawn up for all claims

| Place of search | Date of completion of the search | Examiner |
|---|---|---|
| The Hague | 27 September 2024 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

1

EPO FORM 1503 03.82 (P04C01)

page 1 of 2

Europäisches Patentamt
European Patent Office
Office européen des brevets

# EUROPEAN SEARCH REPORT

Application Number
EP 24 17 5170

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/066544 A1 (WON JEONG-EUN [KR] ET AL) 4 March 2021 (2021-03-04)<br>* paragraphs [0113] - [0117]; figures 1-6 *<br>----- | 1-15 | |
| | | | TECHNICAL FIELDS SEARCHED (IPC) |

1

The present search report has been drawn up for all claims

| Place of search | Date of completion of the search | Examiner |
|---|---|---|
| The Hague | 27 September 2024 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT ON EUROPEAN PATENT APPLICATION NO.

EP 24 17 5170

This annex lists the patent family members relating to the patent documents cited in the above-mentioned European search report. The members are as contained in the European Patent Office EDP file on
The European Patent Office is in no way liable for these particulars which are merely given for the purpose of information.

27-09-2024

| Patent document cited in search report | Publication date | Patent family member(s) | Publication date |
| --- | --- | --- | --- |
| US 2021066544 A1 | 04-03-2021 | KR 20210028410 A | 12-03-2021 |
| | | US 2021066544 A1 | 04-03-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- Solvents and solvent effects in organic chemistry. Wiley VCH publisher, 2003
- *CHEMICAL ABSTRACTS,* 584-09-8